# EUROPEAN PATENT SPECIFICATION

(11) **EP 2 717 378 B1**
(45) Date of publication and mention of the grant of the patent: **13.11.2019**
(21) Application number: 12789508.4
(22) Date of filing: 23.04.2012
(51) Int. Cl.: G01R 31/389

(54) **POWER STORAGE APPARATUS, MOBILE DEVICE, AND ELECTRIC-POWERED VEHICLE**
ENERGIESPEICHERVORRICHTUNG, MOBILE VORRICHTUNG UND ELEKTRISCH ANGETRIEBENES FAHRZEUG
APPAREIL DE STOCKAGE D'ÉNERGIE, DISPOSITIF MOBILE ET VÉHICULE À PROPULSION ÉLECTRIQUE

(30) Priority: 24.05.2011 JP 2011116346
(43) Date of publication of application: 09.04.2014
(73) Proprietor: Panasonic Intellectual Property Management Co., Ltd., Osaka-shi, Osaka 540-6207 (JP)
(72) Inventor: KURANUKI, Masaaki, Osaka 540-6207 (JP)
(74) Representative: Grünecker Patent- und Rechtsanwälte PartG mbB
(86) International application number: PCT/JP2012/002773
(87) International publication number: WO 2012/160754

(56) References cited:
- DE-A1-102009 000 451
- JP-A- 7 322 516
- JP-A- 2006 507 790
- JP-A- 2007 294 322
- JP-A- 2007 294 322
- US-A- 4 743 855

## Description

The technology disclosed herein relates to a power storage apparatus, and a mobile device and an electric-powered vehicle operating after being supplied with power from the power storage apparatus; and particularly relates to an improvement in a power storage apparatus having a function of measuring impedance of a power storage element inside the power storage apparatus.

For measuring impedance of a power storage apparatus represented by a conventional power storage element or a conventional battery pack (assembled battery) obtained by assembling a plurality of power storage elements, a large-sized apparatus represented by products from Solartron Corp (Registered Trademark) are used.

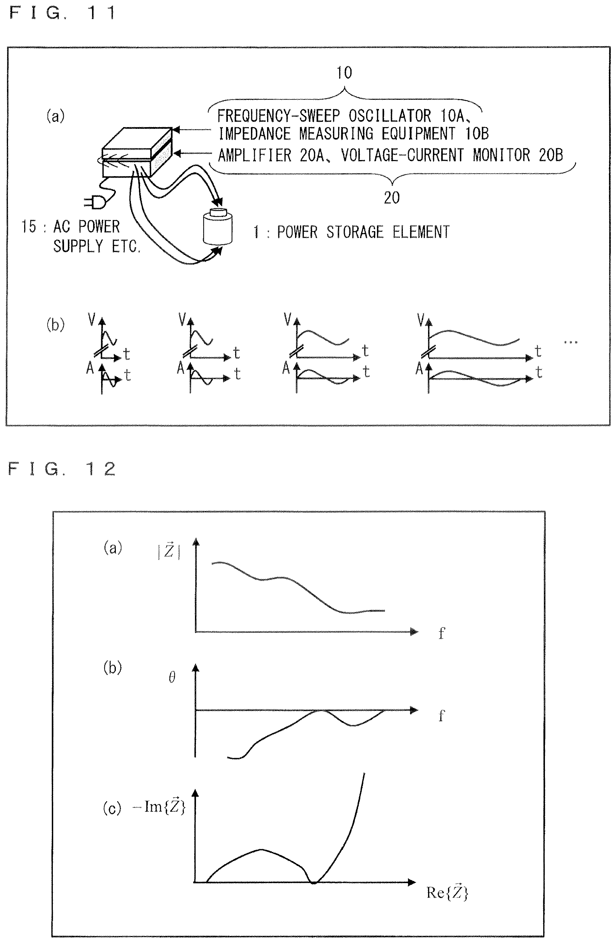

FIG. 11 shows a method for measuring impedance of a power storage element, and shows a schematic diagram of electrochemical measurement using such large-sized system. In (a) of FIG. 11, "1" represents a power storage element, "10" represents a unit that includes a frequency-sweep oscillator 10A and an impedance measuring equipment 10B, and "20" represents a unit that includes an amplifier 20A and a voltage-current monitor 20B. Voltage and current terminals for 4-terminal measurement are mounted on the power storage element I. In addition, the amplifier 20A is supplied with power from an external power supply such as an AC power supply 15. As a measuring procedure, the frequency-sweep oscillator 10A, while changing frequencies step-by-step at an interval of, for example, 10 points/decade, produces a single period of sine wave in each frequency (cf. (b) of FIG. 11). After receiving this sine wave signal, the amplifier 20A provides the power storage element with amplitude of a sine-wave minute current or minute voltage; and the voltage-current monitor 20B monitors voltage or current of the power storage element 1. Based on a response of the monitored voltage/current of the power storage element, the impedance measuring equipment 10B measures impedance of the power storage element 1 (e.g., cf. Patent Literature 1).

FIG. 12 shows impedance characteristic diagrams of a power storage element. (a) of FIG. 12 is a characteristic diagram in which the vertical axis represents absolute value of impedance Z and the horizontal axis represents frequency f, and (b) of FIG. 12 is a characteristic diagram in which the vertical axis represents phase angle θ and the horizontal axis represents frequency f. (c) of FIG. 12 shows a vector locus (so-called cole-cole plot) on a complex plane. It has been general practice to, based on the method for measuring impedance of the power storage element, produce the frequency characteristics of impedance shown in (a) and (b) in FIG. 12 or produce a vector locus (cole-cole plot) on a complex plane shown in (c) of FIG. 12, and evaluate characteristics, deterioration, and reliability of an electrochemical element.

In addition, Patent Literature 2 discloses a method for measuring impedance of each power storage element by charging and discharging among power storage elements forming an assembled battery.
[PTL 1] Specification of United States Patent No. 4743855
[PTL 2] Japanese Laid-Open Patent Publication No 2007-294322

In the context of diversification of needs to utilize power storage apparatuses in electric-powered vehicles etc., there is a demand to increase capacity and voltage of assembled batteries. In order to deal with this demand, a larger number of power storage elements are being connected in series, and an efficient measurement method that can handle such assembled batteries that are connected in series is strongly demanded.

The technology disclosed herein is derived in view of such point, and an objective is to provide a power storage apparatus that has a function of measuring impedance and that can detect a deteriorated power storage element among power storage elements in the power storage apparatus in a short period of time, and a mobile device and an electric-powered vehicle.

This is achieved by the features of the independent claim.

One mode of the technology disclosed herein is a power storage apparatus having a plurality of power storage elements. The apparatus includes: first to fourth power storage elements connected in series; voltage measuring means and current measuring means for respectively measuring voltage and current of each of the first to fourth power storage elements; a first power storage unit including a first switch and a second switch connected in series at both ends of the first power storage element and the second power storage element, and a first inductor on which an inter-terminal voltage of either one of the first power storage element or the second power storage element selected through ON/OFF actions of the first switch and the second switch is applied; a second power storage unit, connected in series with the first power storage unit, including a third switch and a fourth switch connected in series at both ends of the third power storage element and the fourth power storage element, and a second inductor on which an inter-terminal voltage of either one of the third power storage element or the fourth power storage element selected through ON/OFF actions of the third switch and the fourth switch is applied; a fifth switch and a sixth switch connected in series at both ends of the first power storage unit and the second power storage unit; a third inductor on which an inter-terminal voltage of either one of the first power storage unit or the second power storage unit selected through ON/OFF actions of the fifth switch and the sixth switch is applied; and a control section configured to switch ON/OFF of the first to sixth switches at a predetermined timing. The control section switches the fifth switch and the sixth switch to sequentially form a closed circuit including the third inductor and either one of the first power storage unit and the second power storage unit and a closed circuit including the third inductor and the other storage unit, and measures and compares magnitudes of impedances of the first and second power storage units using the voltage measuring means and the current measuring means. When impedance of the first power storage unit is larger, the control section switches the first switch and the second switch to sequentially form a closed circuit including the first inductor and either one of the first power storage element and the second power storage element included in the first power storage unit and a closed circuit including the first inductor and the other storage element, and measures and compares magnitude of impedances of the first power storage element and the second power storage element using the voltage measuring means and the current measuring means to identify the power storage element having a larger impedance. Whereas, when impedance of the second power storage unit is larger, the control section switches the third switch and the fourth switch to sequentially form a closed circuit including the second inductor and either one of the third power storage element and the fourth power storage element included in the second power storage unit and a closed circuit including the first inductor and the other storage element, measures and compares magnitude of impedances of third power storage element and the fourth power storage element using the voltage measuring means and the current measuring means to identify the power storage element having a larger impedance.

Furthermore, in the power storage element described above, preferably, a notification is generated when impedance of the identified power storage element is larger than a predetermined reference value.

Another mode of the technology disclosed herein is also directed toward a power storage apparatus including not less than four power storage elements connected in series. Another mode of the technology disclosed herein is also directed toward a mobile device, an electric-powered vehicle, or the like including the power storage apparatus.

With the technology disclosed herein, a deteriorated power storage element can be detected among power storage elements in a power storage apparatus in a short period of time.
[FIG. 1] FIG. 1 is a circuit diagram showing a configuration of a power storage apparatus according to a first embodiment.
[F1G. 2] FIG. 2 shows state transition of the power storage apparatus according to the first embodiment.
[FIG. 3] FIG. 3 shows the manner how voltage and current are controlled when measuring impedance in the first embodiment.
[FIG. 4] FIG. 4 is a flowchart showing a (low in a normal mode in the first embodiment.
[FIG. 5] FIG. 5 is a flowchart showing a flow in a deterioration mode in the first embodiment.
[FIG. 6] FIG. 6 is a circuit diagram showing a configuration of a power storage apparatus according to a second embodiment.
[FIG. 7] FIG. 7 is a flowchart showing a flow in a normal mode in the second embodiment.
[FIG. 8] FIG. 8 is a flowchart showing a flow in a deterioration mode in the second embodiment.
[FIG. 9] FIG. 9 is a circuit diagram showing basic configuration of a power storage apparatus according to a third embodiment.
[FIG. 10] FIG. 10 is a circuit diagram showing a configuration of a conventional power storage apparatus.
[FIG. 11] FIG. 11 shows a method for measuring impedance of a power storage clement of a conventional power storage apparatus.
[FIG. 12] FIG. 12 is an impedance characteristic diagram of a conventional power storage element.

### DESCRIPTION OF EMBODIMENTS

With conventional technologies described above, there has been a problem of needing a long period of time for measuring impedance of power storage elements one by one. In order to measure impedance of power storage elements, since it is necessary to measure mainly in the range of kHz to mHz or µHz, considerable period of time is required for conducting the measurement for each of the power storage elements. During this period of time, use efficiency is reduced since the power storage apparatus practically cannot be used. In the following, with reference to the drawings, embodiments will be described for a power storage apparatus capable of detecting a deteriorated power storage element in a short period of time.

### First Embodiment

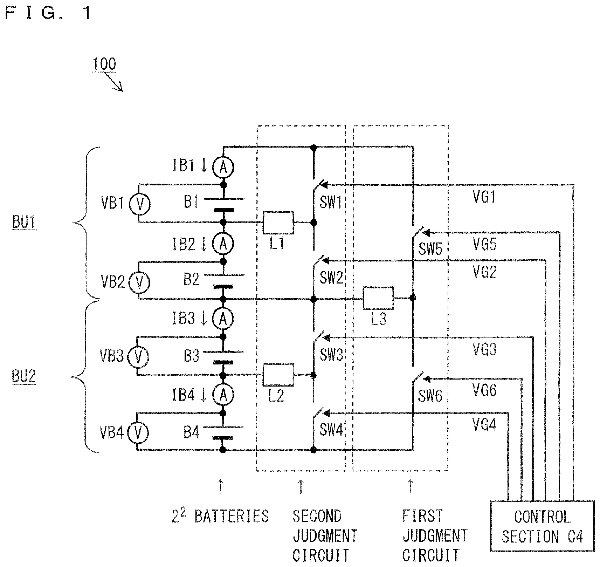

FIG. 1 shows a configuration of a power storage apparatus according to a first embodiment. A power storage apparatus 100 according to the present embodiment has, in one example, four power storage elements. In the power storage apparatus 100, a first power storage element B1, a second power storage element B2, a third power storage element B3, and a fourth power storage element B4 are connected in series. At both ends of the first power storage element B1 and the second power storage element B2, a first switch SW1 and a second switch SW2 are connected in series to form a first switch pair. In addition, at both ends of the third power storage element B3 and the fourth power storage element B4, a third switch SW3 and a fourth switch SW4 are connected in series to form a second switch pair.

Furthermore, a first inductor L1 is connected between a point connecting the first power storage element B1 and the second power storage element B2, and a point connecting the first switch SW1 and the second switch SW2. Furthermore, a second inductor L2 is connected between a point connecting the third power storage element B3 and the fourth power storage element B4, and a point connecting the third switch SW3 and the fourth switch SW4.

The first power storage element B1 and the second power storage element B2 form a first power storage unit BU1. Furthermore, the third power storage element B3 and the fourth power storage element B4 form a second power storage unit BU2.

The first power storage unit BU1 and the second power storage unit BU2 are connected in series, and a fifth switch SW5 and a sixth switch SW6 are connected in series to form a third switch pair. Furthermore, a third inductor L3 is connected between a point connecting the first power storage unit BU1 and the second power storage unit BU2, and a point connecting the fifth switch SW5 and the sixth switch SW6.

The fifth and sixth switches SW5, SW6 and the third inductor L3 form a first judgment circuit; and the first to fourth switches SW1 to SW4 and the first and second inductors L1, L2 form a second judgment circuit.

Furthermore, a control section C4 outputs control signals VG1 to VG6 respectively to the first to sixth switches (SW1 to SW6) to control ON/OFF switching of each of the switches.

The first to sixth switches SW1 to SW6 are switch elements including, for example, a MOSFET or a transistor. The control section C4, while switching these switches, detects current flowing through the first to fourth power storage elements B1 to B4 using ampere meters IB1 to IB4, and detects voltage applied on each of those using volt meters VB1 to VB4. The control section C4 switches ON/OFF the first and second switches SW1, SW2 such that alternating current or voltage, required for measuring impedance of one of the power storage elements between the first and second power storage elements B1, B2, is used for charging the other power storage element or is derived by discharging the other power storage element. Here, the control section C4 switches ON/OFF the first and second switches SW1, SW2 such that there is at least, in a single period of alternating current or voltage, a period of time in which current is supplied from the first power storage element B1 to the first inductor L1, a period of time in which current is supplied from the first inductor L1 to the second power storage element B2, a period of time in which current is supplied from the second power storage element B2 to the first inductor L1, and a period of time in which current is supplied from the first inductor L1 to the first power storage element B1.

In addition, the third and fourth switches SW3, SW4 are switched ON/OFF such that alternating current or voltage, required for measuring impedance of one of the power storage element between the third and fourth power storage elements B3, B4, is used for charging the other power storage element or is derived by discharging the other power storage element. Here, the control section C4 switches ON/OFF the third and fourth switches SW3, SW4 such that there is, in a single period of alternating current or voltage, at least, a period of time in which current is supplied from the third power storage element B3 to the second inductor L2, a period of time in which current is supplied from the second inductor L2 to the fourth power storage element B4, a period of time in which current is supplied from the fourth power storage element B4 to the second inductor L2, and a period of time in which current is supplied from the second inductor L2 to the third power storage element B3. Since impedances of the first to fourth power storage elements B1 to B4 are measured using the second judgment circuit in such manner, this measurement is referred to as a second judgment.

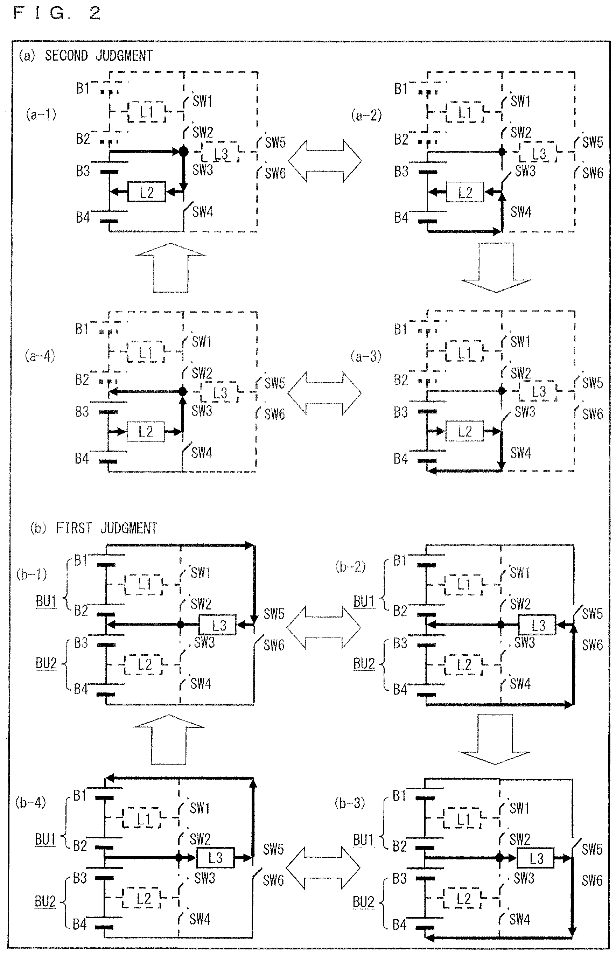

Measuring impedance is conducted with a method described in, for example, Patent Literature 2. In (a) of FIG. 2, a case in which impedance of the fourth power storage element B4 is measured is used as an example, and switch control by the control section C4 and the state of current resulting therefrom is shown. It should be noted that components that do not contribute to the measurement here are shown with dashed lines. First, the third switch SW3 is switched ON by the control section C4. At this moment, as shown with a thick line, current flows from the third power storage element B3 to the second inductor L2 (a-1). Next, the third switch SW3 is switched OFF and the fourth switch SW4 is switched ON. At this moment, current flows from the second inductor L2 to the fourth power storage element B4 (a-2). With these, discharging from the third power storage element B3 to the fourth power storage element B4 is conducted. After repeating this operation once or multiple times, SW4 is switched ON so as to reverse direction of the current of L2, and current flows from the fourth power storage element B4 to the second inductor L2 (a-3). Next, when SW4 is switched OFF, the third switch SW3 is switched ON together. At this moment, current flows from the second inductor L2 to the third power storage element B3 (a-4). With these, charging from the fourth power storage element 4 to the third power storage element B3 is conducted. With the above described cycle, alternating current or voltage can be applied to the fourth power storage element B4, and impedance of the fourth power storage element B4 can be measured. In addition, in a similar manner, impedance of the third power storage element B3 can be measured. Furthermore, impedances of the first and second power storage elements B1, B2 can be measured through similar ON/OFF control of the first and second switches SW1, SW2.

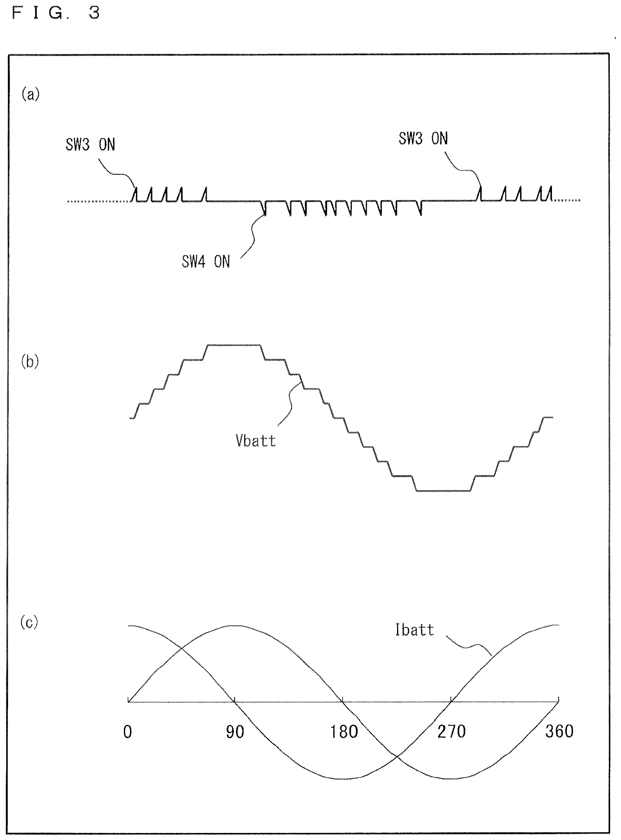

It should be noted that, in practice, the third and fourth switches SW3, SW4 are controlled ON/OFF through, for example, PWM modulation such that sine-wave shaped current or voltage is inputted to each of the power storage elements. FIG. 3 shows an example of changing a current Ibatt and a voltage Vbatt inputted to the fourth power storage element B4 into sine-wave shapes through PWM modulation. As shown in (a) of FIG. 3, when ON/OFF control of the third and fourth switches SW3, SW4 is conducted, a pulse-expressed sine wave of the voltage Vbatt inputted to the fourth power storage element B4 is obtained as shown in (b) of FIG. 3. As a result, as shown in (c) of FIG. 3, the current Ibatt corresponding to the voltage Vbatt is supplied to the fourth power storage element B4.

Furthermore, the control section C4 can also measure impedance at the level of each of the power storage units. The control section C4 switches ON/OFF the fifth and sixth switches SW5, SW6 such that alternating current or voltage, required for measuring impedance of one of the power storage units of the first and second power storage units BU1, BU2, is used for charging the other power storage unit or is derived by discharging the other power storage unit. Here, the control section C4 switches ON/OFF the fifth and sixth switches SW5, SW6 such that there is at least, in a single period of alternating current or voltage, a period of time in which current is supplied from the first power storage unit BU1 to the third inductor L3, a period of time in which current is supplied from the third inductor L3 to the second power storage unit BU2, a period of time in which current is supplied from the second power storage unit BU2 to the third inductor L3, and a period of time in which current is supplied from the third inductor L3 to the first power storage unit BU1. Since impedances of the first and second power storage units BU1, BU2 are measured using the first judgment circuit in such manner, this measurement is referred to as a first judgment.

In (b) of FIG. 2, a case in which impedance of the second power storage unit BU2 is measured is used as an example, and switch control by the control section C4 and the state of current resulting therefrom are shown. First, only the fifth switch SW5 is switched ON by the control section C4. At this moment, as shown with a thick line, current flows from the first power storage unit BU1 to the third inductor L3 (b-1). Next, the fifth switch SW5 is switched OFF and the sixth switch SW6 is switched ON. At this moment, current flows from the third inductor L3 to the second power storage unit BU2 (b-2). With these, discharging from the second power storage unit BU2 to the first power storage unit BU1 is conducted. After repeating this operation once or multiple times, SW6 is switched ON so as to reverse direction of the current of L3, and current flows from the second power storage unit BU2 to the third inductor L3 (b-3). Next, when SW6 is switched OFF, the fifth switch SW5 is switched ON together. At this moment, current flows from the third inductor L3 to the first power storage unit BU1 (b-4). With these, charging from the second power storage unit BU2 to the first power storage unit BU1 is conducted. With the above described cycle, alternating current or voltage can be applied to the first power storage unit BU1, and impedance of the first power storage unit BU1 can be measured. In addition, in a similar manner, impedance of the first power storage unit BU1 can be measured. It should be noted that, in practice, the fifth and sixth switches SW5, SW6 are controlled ON/OFF similarly to the third and fourth switches SW3, SW4 in FIG. 3 through, for example, PWM modulation such that sine-wave shaped current or voltage is inputted to each of the power storage units.

Furthermore, for such measurement of impedance, a method described in, for example, Japanese Patent No. 4138502 may be used.

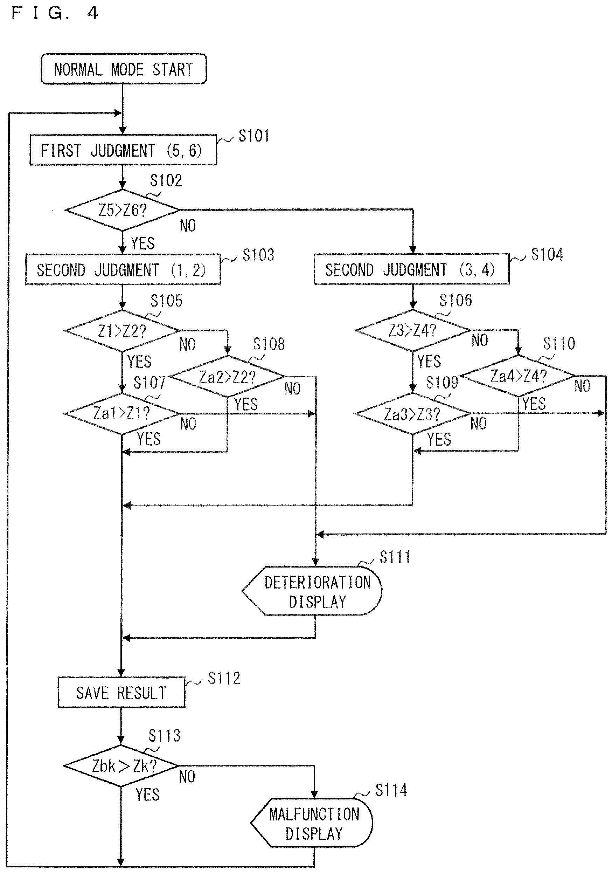

In the following, a flow for measuring impedance by the power storage apparatus 100 will be described. FIG. 4 shows a flowchart of a basic operation of an impedance-measurement process by the power storage apparatus 100. The basic operation consists of a normal mode operation.
(1) After receiving an instruction to start measuring impedance in the normal mode, the control section C4 repeats a cyclic operation of charging and discharging the first power storage unit BU1 with the above described method, measures current flowing through the first power storage unit BU1 using the ampere meter IB1 or IB2, and measures electrical potential difference of both ends of the first power storage unit BU1 using the volt meters VB1 and VB2, to measure an impedance Z5 of the first power storage unit BU1 in a charge-and-discharge cycle. Similarly the control section C4 repeats a cyclic operation of charging and discharging the second power storage unit BU2, measures current flowing through the second power storage unit BU2 using the ampere meter IB3 or IB4, and measures electrical potential difference of both ends of the second power storage unit BU2 using the volt meters VB3 and VB4, to measure an impedance Z6 of the second power storage unit BU2 in a charge-and-discharge cycle (step S101).
(2) The control section C4 judges whether or not the impedance Z5 of the first power storage unit BU1 is larger than the impedance Z6 of the second power storage unit BU2 (step S102).
(3) As a result, the control section C4 selects a power storage unit having a larger impedance, and measures impedances of every power storage elements included in the power storage unit. In the following, description will be provided supposing that Z5 is smaller than Z6 (NO at step S105) and that the second power storage unit BU2 is selected.
(4) The control section C4 measures impedances of the power storage elements included in the selected power storage unit using the above described method (steps S103, S104). Here, step S104 is executed. The control section C4 repeats a cyclic operation of charging and discharging the third power storage element B3, measures current flowing through the third power storage element B3 using the ampere meter IB3, and measures electrical potential difference of both ends of the third power storage element B3 using the volt meter VB3, to measure an impedance Z3 of the third power storage element B3 in a charge-and-discharge cycle. Furthermore, similarly, the control section C4 repeats a cyclic operation of charging and discharging the fourth power storage element B4, measures current flowing through the fourth power storage element B4 using the ampere meter IB4. and measures electrical potential difference of both ends of the fourth power storage element B4 using the volt meter VB4, to measure an impedance Z4 of the fourth power storage element B4 in a charge-and-discharge cycle (step S104).
(5) The control section C4 judges the magnitude of the measured impedances of each of the power storage elements (step S105, S106). Here, step S106 is executed, and it is judged whether or not the impedance Z3 of the third power storage element B3 is larger than the impedance Z4 of the fourth power storage element B4 (step S106).
(6) As a result, the control section C4 selects a power storage element Bk (k=1, 2,..., 4) having a large impedance. In the following, description will be provided supposing that Z3 is smaller than Z4 (NO at step S106) and that the fourth power storage element B4 is selected. The control section C4 compares the impedance of the selected power storage element Bk and a first reference value Zak (k=1, 2,..., 4) that corresponds to the power storage element Bk and is pre-stored or calculated each time from parameters such as temperature and SOC (charging state) (step S 107 to S110). Here, step S110 is executed, and Z4 and Za4 are compared. As a result, when the impedance is larger than the first reference value (in this case, when Z4 is larger than Za4 (NO at step S110)), it is judged that the power storage element (the fourth power storage element B4) has deteriorated, and the judgment is displayed on a display section (not shown) or transmitted to an external apparatus (step S111). Then, the control section C4 records and saves deterioration information including, for example, an identifier (B4), the impedance (Z4), and the like of the power storage element as an execution result (step S112). Furthermore, when the impedance is smaller than the first reference value (in this case, when Z4 is smaller than Za4 (YES at step S110)), step S111 is not executed and the flow shifts to step S112, and information or the like indicating that there is no deterioration in each of the power storage elements is recorded and saved as an execution result.
   Since replacement of a power storage element based on this deterioration information is prompted, maintainability of the power storage apparatus increases.
(7) The control section C4 further compares an impedance Zk of the power storage element Bk judged to have the highest impedance among those that have been measured (here, the impedance Z4 of the fourth power storage element B4) and a second reference value Zbk that corresponds to the power storage element Bk and is pre-stored in the control section C4 or calculated each time from parameters such as temperature and SOC (here, compares Z4 and Zb4) (step S113). When the impedance Zk is larger than the second reference value Zbk (in this case, when Z4 is larger than Zb4) (NO at step S113), it is judged that the power storage element (in this case, the fourth power storage element B4) is malfunctioning, and the judgment is displayed on a display section or transmitted to an external apparatus (step S114). Furthermore, when the impedance is smaller than the second reference value (in this case, when Z4 is smaller than Zb4) (YES at step S113), step S114 is not executed.

Here, the first reference value and the second reference value can be suitably determined. For example, they may be determined respectively as an impedance value when slight performance deterioration has occurred in a power storage element, and an impedance value when serious performance deterioration has occurred in a power storage element.

By doing so, a user or an administrator of the power storage apparatus 100 who have been notified to replace the fourth power storage element B4 as a warning can recognized that a replacement is necessary. (8) Then, the control section C4 returns the flow to step S101 again at an appropriate time such as an unused time slot learnt in advance as a time slot during which the power storage apparatus 100 is not charged or discharged, or after elapsing of a period of time determined in advance. With this, the function as a power storage apparatus can be exerted until then.

By repeating the above described steps, impedance of a deteriorated power storage element, which becomes a bottleneck for the performance of the power storage apparatus 100, can be accurately obtained in a short period of time, and the user or administrator can be provided with information required for replacement. In addition, measurement can be conducted further accurately by following the method described in Japanese Patent No. 4138502.

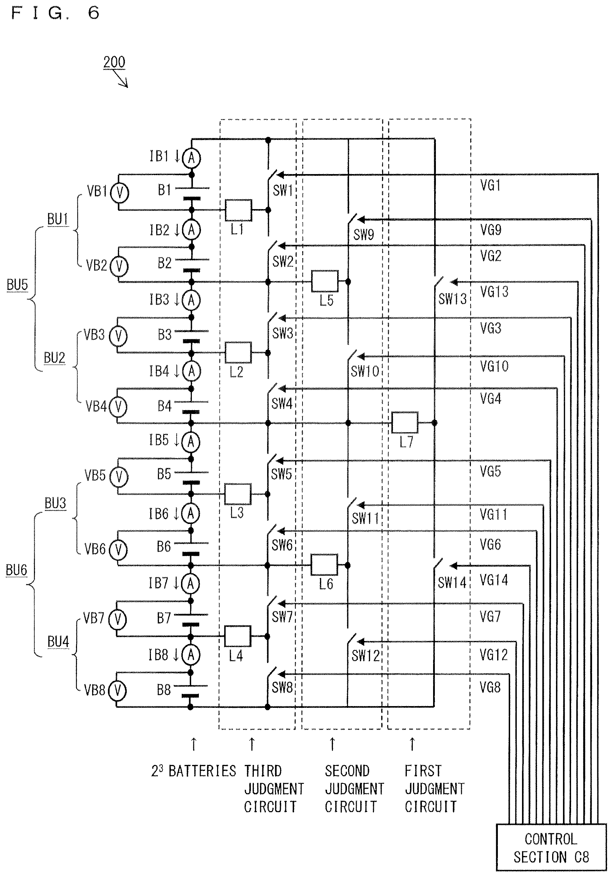

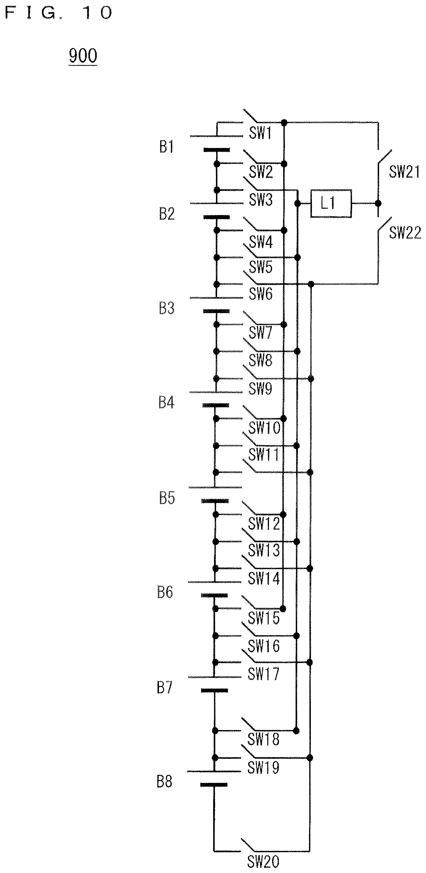

Here, for simplicity, although a power storage apparatus having four in-series connections has been used as an example,

in a conventional power storage apparatus having a large number of in-series connections, if the method of forming switches simply at both ends of a power storage element is adopted, the number of switches and the number of wiring and circuits for controlling those become enormous. For example, when there are eight in-series connections, as can be figured out from a comparison between FIG. 6 and FIG. 10, the number of switches can be reduced from 22 to 14. With this, ON/OFF signals for the switches can be reduced, and components and cost thereof can also be reduced.

The switch formed inside the power storage apparatus is envisioned to be a MOSFET or a transistor, and in a case with a MOSFET, it is necessary to have a voltage source having a voltage of about several volts to 10 volts with respect to a source potential, and apply a gate potential in accordance with a control signal to conduct the ON/OFF control. In a case with a transistor, it is necessary to obtain a base current source corresponding to collector current, in order to apply a voltage equal to or higher than 0.7 volts with respect to an emitter potential for supplying current from the base to an emitter. For this, it is necessary to prepare charge pump circuits and isolated DC/DC converters by a quantity corresponding to each electric potential.

On the other hand, since each of the switches fixes a respective power storage element to a source potential or an emitter potential, it is necessary to insulate a signal VG1 or the like from the control section C4 or supply a base current or a gate voltage using a level shift circuit having necessary voltage with standability. For that, signal transmission circuit components utilizing magnetic coupling or optical isolation represented by photo couplers, photo MOS, pulse transformers, and i-couplers are also needed by a quantity of the switches.

Since the cost of such components is reflected in the cost of the power storage apparatus, it is overwhelmingly advantageous to have a small number of switches for providing the apparatus cheaply.

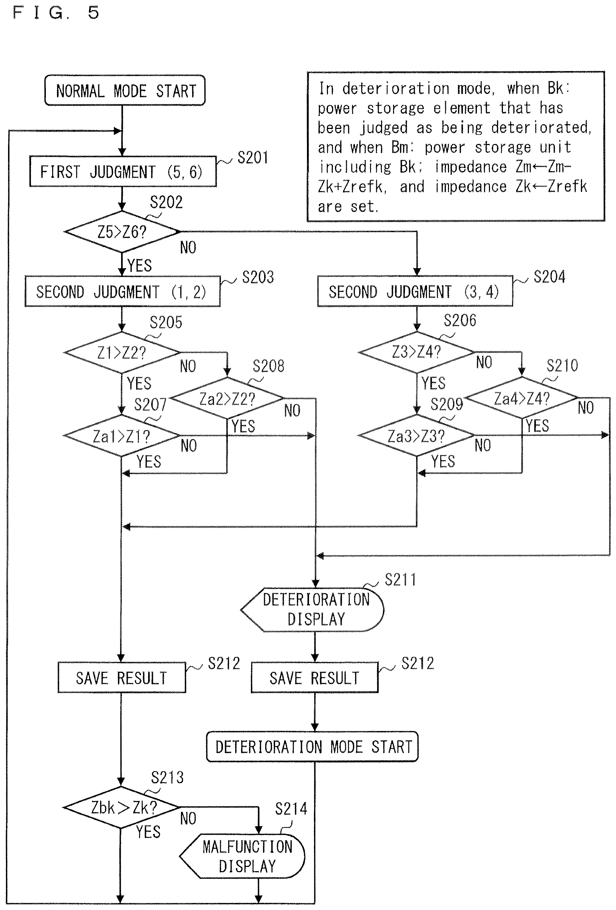

Next, an applicational operation of the impedance-measurement process of the power storage apparatus 100 will be described. With reference to FIG. 5, processes in the applicational operation will be described. In the present applicational operation, the processes in the normal mode are conducted similarly to the basic operation described above, and then, in accordance with a processing result, processes in a deterioration mode are further executed.
(1) The control section C4 first executes steps S201 to S214. When these steps are executed for the first time, they are similar to steps S101 to S114 in the normal mode in the basic operation. However, when step S211 is executed, the results are saved (step S212) and then the flow shifts to processes in a deterioration mode.
(2) After shifting to the deterioration mode, the control section C4 repeats execution of steps S201 to S214. In this case, in steps S201 to step S210, with regard to an impedance Zm of a power storage unit Bm including the power storage element Bk (k=1, 2,..., 4) that has already been judged to have deterioration occurred therein, the processes are conducted using, as Zm, a value obtained by subtracting (Zk-Zrefk) from an actually measured Zm. Here, Zrefk is a predetermined reference value of the impedance of the power storage element Bk, and is determined, for example, by the value of the impedance of the power storage element Bk when there is no deterioration. Therefore, (Zk-Zrek) can be considered as an amount of increase (deterioration amount) of the impedance of the power storage element Bk. Thus, Zm-(Zk-Zrefk) which is used in the processes instead of Zm is an estimated value of the impedance of the power storage unit Bm when it is assumed that there is no deterioration in the power storage element Bk.

For example, when it is judged that the fourth power storage element B4 is deteriorated, a measured value Z6 of the impedance of the second power storage unit BU2 (B6) including the fourth power storage element B4 contains a deterioration amount of the impedance of the fourth power storage apparatus B4. However, the value of Z6-(Z4-Zref4) becomes an estimated value of the impedance of the second power storage unit BU2 (B6) when there is no deterioration of the fourth power storage unit B4, since the deterioration amount is subtracted from Z6.

Furthermore, in steps S201 to step S210, with regard to the impedance Zk of the power storage element Bk that has already been judged to have deterioration occurred therein, the control section C4 conducts the processes using Zrefk as Zk. Thus, these processes are conducted as there is no deterioration in the power storage element Bk. Therefore, at step S203 or step S204, with regard to the power storage element Bk, it is not necessary to measure its impedance Zk. For example, when it is judged that the fourth power storage element B4 is deteriorated, its impedance Z4 does not have to be measured at step S204.

By substituting the value of the impedance for the power storage element Bk and the power storage unit Bm including thereof, the power storage element Bk is excluded as a subject for a deterioration judgment. By repeating this, judgment of deterioration can be made for other power storage elements whose performances are deteriorated the second most or less.

It should be noted that, at step S213, the control section C4 does not conduct such substitution of impedance values, and conducts the judgment based on the impedance value Zk that has been actually measured most recently. Therefore, when the impedance Zk of the power storage element Bk is not measured at step S203 or step S204, the impedance Zk is preferably measured, for example, between step S212 and step S213.

It should be noted that, when comparison of magnitude of impedances in the basic operation and the applicational operation resulted in equal, the flow may be advanced to either YES or NO. In either case, it is possible to give a deterioration judgment or a malfunction judgment to one among multiple power storage elements that have been deteriorated to the same degree. In addition, by repeatedly executing the deterioration mode in the applicational operation, deterioration judgment can be sequentially given to all of the multiple power storage elements whose performances have deteriorated. Execution of the deterioration mode is preferably repeated in the above described unused time slot, or after elapsing of a period of time determined in advance.

Even when there are multiple deterioration judgment, if the procedure of the deterioration judgment is changed to that in FIG. 5, until a malfunction judgment is been made, the user can use the power storage apparatus within the range of the performance of the power storage element while understanding that there are multiple deteriorations, until it is judged to have malfunctioned.

In this case, although there is one additional step at the end for measuring the power storage element that has first judged to be deteriorated, and the time required for measurements increases accordingly, when compared to inspecting all, the number of inspections can be reduced as the number of in-series connected power storage elements increases, and the advantageous effect of the present embodiment becomes significant.

With this, for example, assuming a case where deteriorations of power storage elements have progressed almost equivalently, the user or administrator can continue using the power storage apparatus within a range of its performance while understanding the state of the deteriorated power storage element until a malfunctioning power storage element that becomes a bottleneck of its performance emerges.

This information is extremely important in use applications in which a sudden halt of operation due to battery malfunction becomes a problem. Such applications are cases in which maintenance is extremely troublesome unless a certain degree of deterioration is accepted while it is too late to deal with that once a critical defect emerges, and examples of such cases include, needless to say, movable bodies such as vehicles, backup power storage apparatuses for communication stations set at mountainous areas and islandy areas, and power storage apparatuses for natural energy sources such as solar batteries.

The advantageous effect of the present embodiment is summarized as follows.
(1) By being able to accurately measure and understand judgment of deteriorating cell that becomes a bottleneck for a power storage apparatus in a short period of time, it is possible to conduct a detailed battery test and judge deteriorating cells. In addition, a prediction of effective battery life can be achieved.
(2) It is possible to have fine portability and simplicity that had been conventionally available, retain a characteristic of being able to measure impedance of a power storage element using unused time such as nighttime, dramatically reduce the number of switches necessary for measuring impedance associated with the increase in the number of in-series connections in the power storage apparatus, and, as a result, largely reduce the circuit scale of drive circuits. In addition, the cost will also become low.
(3) When a deteriorating power storage element having increased impedance emerges in a power storage apparatus, it is possible to show the deteriorating power storage element to the user or administrator, or transmit the information to prompt a replacement, and also continue its usage as a power storage apparatus.
(4) When it is determined that the deterioration state has advanced further, it is possible to give a warning to replace the one determined as malfunctioning, restrict operation as a power storage apparatus for the purpose of ensuring safety, prepare a replacement power storage element quickly, and improve maintainability of the power storage apparatus since the target to be replaced can be figured out.
(5) By conducting the replacement at a power storage element level, unnecessary cost can be reduced when compared to replacing the whole power storage apparatus.

### Second Embodiment

FIG. 6 shows a configuration of a power storage apparatus according to a second embodiment. A power storage apparatus 200 according to the present embodiment has, in one example, eight power storage elements. In the power storage apparatus 200, first to eighth power storage elements B1 to B8 are connected in series. At both ends of the first power storage element B1 and the second power storage element B2, the first switch SW1 and the second switch SW2 are connected in series to form the first switch pair. In addition, at both ends of the third power storage element B3 and the fourth power storage element B4, the third switch SW3 and the fourth switch SW4 are connected in series to form the second switch pair. At both ends of a fifth power storage element B5 and a sixth power storage element B6, the fifth switch SW5 and the sixth switch SW6 are connected in series to form the third switch pair. In addition, at both ends of a seventh power storage element B7 and an eighth power storage element B8, a seventh switch SW7 and an eighth switch SW8 are connected in series to form the second switch pair.

Furthermore, the first inductor L1 is connected between a point connecting the first power storage element B1 and the second power storage element B2, and a point connecting the first switch SW1 and the second switch SW2. Further, the second inductor L2 is connected between a point connecting the third power storage element B3 and the fourth power storage element B4, and a point connecting the third switch SW3 and the fourth switch SW4. Still further, the third inductor L3 is connected between a point connecting the fifth power storage element B5 and the sixth power storage element B6, and a point connecting the fifth switch SW5 and the sixth switch SW6. In addition, a fourth inductor L4 is connected between a point connecting the seventh power storage element B7 and the eighth power storage element B8, and a point connecting the seventh switch SW7 and the eighth switch SW8.

The first power storage element B1 and the second power storage element B2 form the first power storage unit BU1. Furthermore, the third power storage element B3 and the fourth power storage element B4 form the second power storage unit BU2. The fifth power storage element B5 and the sixth power storage element B6 form a third power storage unit BU3. Furthermore, the seventh power storage element B7 and the eighth power storage element B8 form a second power storage unit BU4.

The first power storage unit BU1 and the second power storage unit BU2 are connected in series, and a ninth switch SW9 and a tenth switch SW10 are connected in series to form a fifth switch pair. Furthermore, a fifth inductor L5 is connected between a point connecting the first power storage unit BU1 and the second power storage unit BU2, and a point connecting the ninth switch SW9 and the tenth switch SW10. The third power storage unit BU3 and the fourth power storage unit BU4 are connected in series, and an eleventh switch SW11 and a twelfth switch SW12 are connected in series to form a sixth switch pair. Furthermore, a sixth inductor L6 is connected between a point connecting the third power storage unit BU3 and the fourth power storage unit BU4, and a point connecting the eleventh switch SW11 and the twelfth switch SW12.

The first power storage unit BU1 and the second power storage unit BU2 form a fifth power storage unit BU5. Furthermore, the third power storage unit BU3 and the fourth power storage unit BU4 form a sixth power storage unit BU6. It should be noted that, for convenience, the fifth and sixth power storage units BU5, BU6 are each regarded as one power storage element, and are referred also with reference characters B13 and B14.

The fifth power storage unit BU5 and the sixth power storage unit BU6 are connected in series, and a thirteenth switch SW13 and a fourteenth switch SW14 are connected in series to form a seventh switch pair. Furthermore, a seventh inductor L7 is connected between a point connecting the fifth power storage unit BU5 and the sixth power storage unit BU6, and a point connecting the thirteenth switch SW13 and the fourteenth switch SW14.

The thirteenth and fourteenth switches SW13, SW14 and the seventh inductor L7 form the first judgment circuit; the ninth to twelfth switches SW9 to SW12 and the fifth and sixth inductors L5, L6 form the second judgment circuit; and the first to eighth switches SW1 to SW8 and the first to fourth inductors L1 to L4 form a third judgment circuit.

Furthermore, a control section C8 outputs control signals VG1 to VG14 respectively to the first to fourteenth switches (SW1 to SW14) to control ON/OFF switching of each of the switches.

The first to fourteenth switches SW1 to SW14 are switch elements including, for example, a MOSFET or a transistor. The control section C8, while switching these switches, detects current flowing through the first to eighth power storage elements B1 to B8 using ampere meters IB1 to IB8, and detects voltage applied on each of those using volt meters VB1 to VB8.

Similarly to the control section C4 of the first embodiment, the control section C8 can measure impedances of every power storage elements and every power storage units. For example, with regard to the fifth power storage unit and the sixth power storage unit, impedances thereof can be measured by controlling ON/OFF of the thirteenth and fourteenth switches SW13, SW14. Since impedances of the fifth and sixth power storage units BU5, BU6 are measured using the first judgment circuit in such manner, this measurement is referred to as a first judgment. Similarly, since impedances of the first to fourth power storage unit BU1 to BU4 are measured using the second judgment circuit in such manner, this measurement is referred to as a second judgment. Furthermore, since impedances of the first to eighth power storage elements B1 to B8 are measured using the third judgment circuit in such manner, this measurement is referred to as a third judgment.

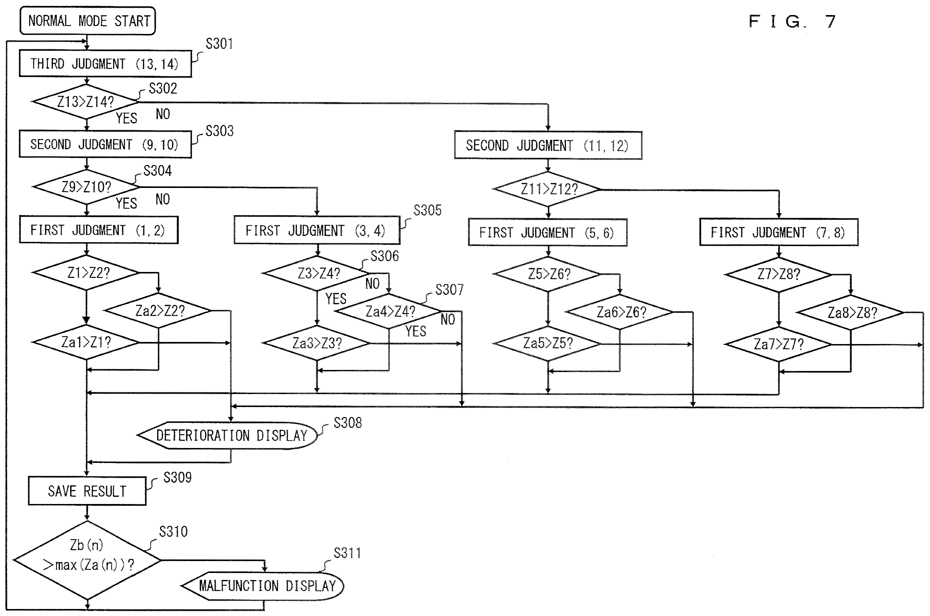

In the following, a flow for measuring impedance by the power storage apparatus 200 will be described. FIG. 7 shows a flowchart of a basic operation of an impedance-measurement process by the power storage apparatus 200. The basic operation consists of a normal mode operation. It should be noted that, when compared to the flow of processes in the first embodiment, the flow of processes here is different only regarding a point that there is one more process for measuring and judging impedance. In order to simplify the description, a case in which the fourth power storage element B4 is deteriorated the most and its impedance Z4 is the largest is described as an example. Furthermore, reference characters, except for one portion thereof, showing steps in the drawing are omitted.
(1) After receiving an instruction to start measuring impedance in the normal mode, the control section C8 measures an impedance Z13 of the fifth power storage unit BU5 and an impedance Z14 of the sixth power storage unit BU6 (step S301).
(2) The control section C8 judges whether or not the impedance Z13 of the fifth power storage unit BU5 is larger than impedance Z14 of the sixth power storage unit BU6 (step S302).
(3) As a result, the control section C8 selects the fifth power storage unit BU5 (B13) having a larger impedance (YES at step S302).
(4) The control section C8 measures impedances Z9, Z10 of the first and second power storage units BU1, BU2 included in the selected fifth power storage unit BU5 (step S303).
(5) The control section C8 judges whether or not the impedance Z9 of the first power storage unit BU1 is larger than impedance Z10 of the second power storage unit BU2 (step S304).
(6) As a result, the control section C8 selects the second power storage unit BU2 (B10) having a larger impedance (NO at step S304).
(7) The control section C8 measures impedances Z3, Z4 of the third and fourth power storage elements B3, B4 included in the selected second power storage unit BU2 (step S305).
(8) The control section C8 judges whether or not the impedance Z3 of the third power storage element B3 is larger than the impedance Z4 of the fourth power storage element B4 (step S306).
(9) As a result, the control section C8 selects the fourth power storage element B4 having a larger impedance (NO at step S306).
   The control section C8 compares the impedance of the selected fourth power storage element B4 and a first reference value Za4 that corresponds to the fourth power storage element B4 and is pre-stored or calculated each time from parameters such as temperature and SOC (charging state) (step S307). As a result, when the impedance Z4 is larger than the first reference value Za4 (NO at step S307), it is judged that the fourth power storage element B4 has deteriorated, and the judgment is displayed on a display section (not shown) or is transmitted to an external apparatus (step S308). Then, the control section C8 records and saves deterioration information including, for example, an identifier, the impedance (Z4), and the like of the fourth power storage element B4 as an execution result (step S309). Furthermore, when the impedance Z4 is smaller than the first reference value Za4 (YES at step S307), step S308 is not executed and the flow shifts to step S309, and information or the like indicating that, for example, there is no deterioration in each of the power storage element is recorded and saved as an execution result.
(10) The control section C8 compares the impedance Z4 of the fourth power storage element B4 and a second reference value Zb4 that corresponds to the power storage element B4 and is pre-stored by the control section C8 or calculated each time from parameters such as temperature and SOC (step S310). When the impedance Z4 is larger than the second reference value Zb4 (NO at step S310), it is judged that the fourth power storage element B4 is malfunctioning, and the judgment is displayed on a display section or is transmitted to an external apparatus (step S311). Furthermore, when the impedance Z4 is smaller than the second reference value Zb4 (YES at step S310), step S311 is not executed.
   Here, the first reference value and the second reference value can be suitably determined. For example, they may be determined respectively as an impedance value when slight performance deterioration has occurred in a power storage element, and an impedance value when serious performance deterioration has occurred in a power storage element.
(11) Then, the control section C8 returns the flow to step S301 again at an appropriate time such as an unused time slot learnt in advance as a time slot during which the power storage apparatus 200 is not charged or discharged, or after elapsing of a period of time determined in advance. With this, the function as a power storage apparatus can be exerted until then.

By repeating the above described steps, impedance of a deteriorated power storage element, which becomes a bottleneck for the performance of the power storage apparatus 200, can be accurately obtained in a short period of time, and the user or administrator can be provided with information required for replacement. In addition, measurement can be conducted further accurately by following the method described in Japanese Patent No. 4138502.

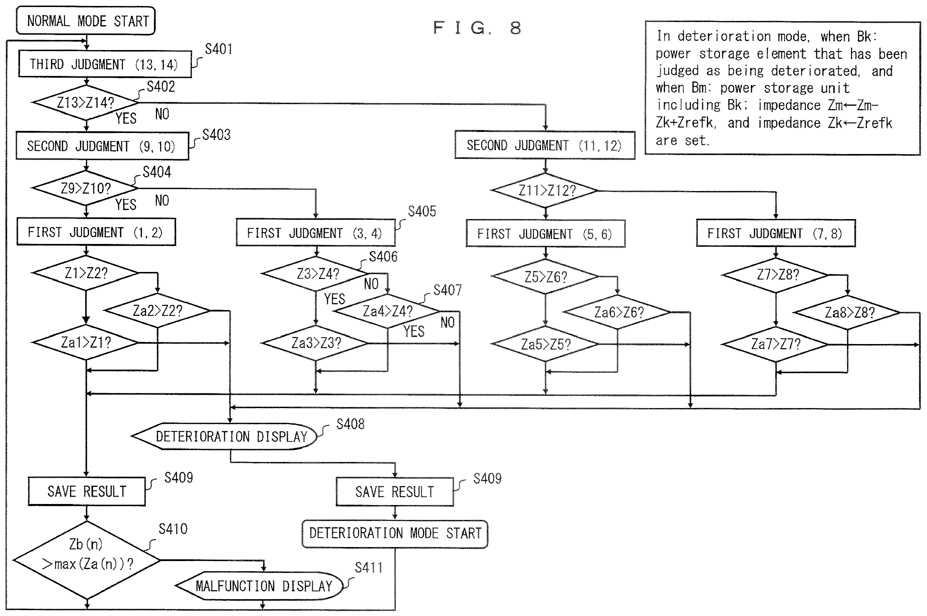

Next, an applicational operation of the impedance-measurement process of the power storage apparatus 200 will be described. With reference to FIG. 8, processes in the applicational operation will be described. In the present applicational operation, the processes in the normal mode are conducted similarly to the basic operation described above, and then, in accordance with a processing result, processes in a deterioration mode are further executed. Also in the following, a case in which the fourth power storage element B4 is deteriorated the most and its impedance Z4 is the largest is described as an example. Furthermore, reference characters, except for one portion thereof, showing steps in the drawing are omitted.
(1) The control section C8 first executes steps S401 to S411. When these steps are executed for the first time, they are similar to steps S301 to S314 in the normal mode in the basic operation. However, when step S408 is executed, the results are saved (step S409) and then the flow shifts to processes in a deterioration mode.
(2) After shifting to the deterioration mode, the control section C8 repeats execution of steps S401 to S411. In this case, with regard to the impedance Zm of the power storage unit Bm (k=1, 2,..., 6) including the power storage element Bk (k=1, 2,..., 8) that has already been judged to have deterioration occurred therein, the processes in steps S401 to S411 are conducted using, as Zm, a value obtained by subtracting (Zk-Zrefk) from an actually measured Zm. Here, Zrefk is a predetermined reference value of the impedance of the power storage element Bk, and is determined, for example, by the value of the impedance of the power storage element Bk when there is no deterioration. Therefore, (Zk-Zrek) can be considered as an amount of increase (deterioration amount) of the impedance of the power storage element Bk. Thus, Zm-(Zk-Zrefk) which is used in the processes instead of Zm is an estimated value of the impedance of the power storage unit Bm when it is assumed that there is no deterioration in the power storage element Bk.

For example, when it is judged that the fourth power storage element B4 is deteriorated, a measured value Z10 of the impedance of the second power storage unit BU2 (B10) including the fourth power storage element B4 contains a deterioration amount of the impedance of the fourth power storage apparatus B10. However, the value of Z10-(Z4-Zref4) becomes an estimated value of the impedance Z10 of the second power storage unit BU2 (B10) when there is no deterioration of the fourth power storage unit B4, since the deterioration amount is subtracted from Z10.

Furthermore, with regard to the impedance Zk of the power storage element Bk that has already been judged to have deterioration occurred therein, the control section C8 conducts the processes using Zrefk as Zk. Thus, these processes are conducted as there is no deterioration in the power storage element Bk. Therefore, with regard to the power storage element Bk, it is not necessary to measure its impedance Zk. For example, when it is judged that the fourth power storage element B4 is deteriorated, its impedance Z4 does not have to be measured at step S405.

By substituting the value of the impedance for the power storage element Bk and the power storage unit Bm including thereof, the power storage element Bk is excluded as a subject for a deterioration judgment. By repeating this, judgment of deterioration can be made for other power storage elements whose performances are deteriorated the second most or less.

It should be noted that, at step S410, the control section C8 does not conduct such substitution of impedance values, and conducts the judgment based on the impedance value Zk that has been actually measured most recently. Therefore, for example, when the impedance Z4 of power storage element B4 is not measured at step S405, the impedance Z4 is preferably measured, for example, between step S409 and step S410.

It should be noted that, when comparison of magnitude of impedances in the basic operation and the applicational operation resulted in equal, the flow may be advanced to either YES or NO. In either case, it is possible to give a deterioration judgment or a malfunction judgment to one among multiple power storage elements that have been deteriorated to the same degree. In addition, by repeatedly executing the deterioration mode in the applicational operation, deterioration judgment can be sequentially given to all of the multiple power storage elements whose performances have deteriorated.

In addition, the present embodiment is an embodiment that partially includes the power storage apparatus 100 according to the first embodiment, and is an extended configuration having eight power storage elements, and thereby has the same advantageous effect as that of the first embodiment.

### Third Embodiment

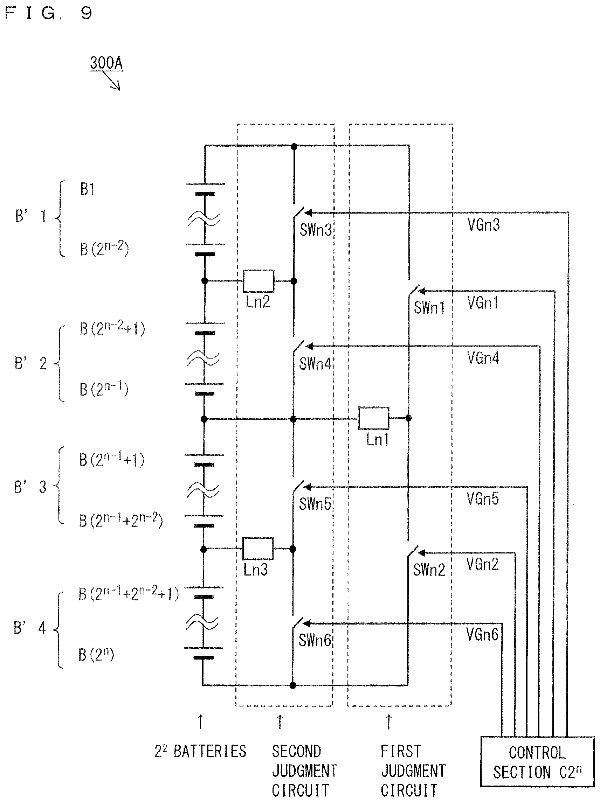

FIG. 9 shows a basic configuration example of a power storage apparatus according to the third embodiment. It should be noted that the assignment rule of the numbers in the reference characters of each component described in the following is different from that of the first and second embodiments for convenience of description. Therefore, the reference characters are denoted with an "n" before the numbers. A power storage apparatus 300A according to the present configuration example has, in one example, 2ⁿ (n is 3 or larger) power storage elements B1 to B(2ⁿ) connected in series in an order of the numbers in the reference characters. At both ends of a group of continuous 2ⁿ⁻¹ power storage elements B1 to B(2ⁿ⁻¹), n3-th and n4-th switches SWn3, SWn4 are connected in series. Furthermore, at both ends of a group of continuous 2ⁿ⁻¹ power storage elements B(2ⁿ⁻¹+1) to B(2ⁿ), n5-th and n6-th switches SWn5, SWn6 are connected in series.

Furthermore, an n2-th inductor Ln2 is connected between a point connecting a power storage element B(2ⁿ⁻²) and a power storage element B(2ⁿ⁻²+1), and a point connecting the n3-th switch SWn3 and the n4-th switch SWn4. Furthermore, an n3-th inductor Ln3 is connected between a point connecting a power storage element B(2ⁿ⁻¹+2ⁿ⁻²) and a power storage element B(2ⁿ⁻¹+2ⁿ⁻²+1), and a point connecting the n5-th switch SWn5 and the n6-th switch SWn6.

The group of power storage elements B1 to B(2ⁿ⁻¹) forms an n1-th power storage unit BUn1. The group of power storage elements B(2ⁿ⁻¹+1) to B(2ⁿ) forms an n2-th power storage unit BUn2.

The n1-th power storage unit BUn1 and the n2-th power storage unit BUn2 are connected in series, and an n1-th switch SWn1 and an n2-th switch SWn2 are connected in series. Furthermore, an n1-th inductor Ln1 is connected between a point connecting the n1-th power storage unit BUn1 and the n2-th power storage unit BUn2, and a point connecting the n1-th switch SWn1 and the n2-th switch SWn2.

The n1-th and n2-th switches SWn1, SWn2 and the n1-th inductor Ln3 form an n1 judgment circuit, and the n3 to n6-th switches SWn3 to SWn6 and the n2-th and n3-th inductors Ln2, Ln3 form the second judgment circuit.

Furthermore, a control section C2ⁿ outputs control signals VGn1 to VGn6 respectively to the n1-th to n6-th switches (SWn1 to SWn6) to control ON/OFF switching of each of the switches. Similarly to the first and second embodiments, although an ampere meter and a volt meter are connected to each of the power storage elements B1 to B2ⁿ, diagrammatic representations thereof are omitted.

When the four groups of power storage elements B1 to B(2ⁿ⁻²), B (2ⁿ⁻²+1) to B (2ⁿ⁻¹), B (2ⁿ⁻¹+1) to B(2ⁿ⁻¹+2ⁿ⁻²+1) are respectively regarded as power storage elements B'1 to B'4; the power storage apparatus 300A will have a configuration similar to that of the power storage apparatus 100 according to the first embodiment. Therefore, similarly to the first embodiment, by conducting the processes in the normal mode and the deterioration mode in an order of the first judgment and the second judgment, it is possible to identify an element having the largest impedance among the power storage elements B'1 to B'4 with a small number of measurements, efficiently detect a group of power storage elements whose performances have deteriorated, and provide a display indicating deterioration or a display indicating malfunction.

It should be noted that, for example, even with a power storage apparatus 900 disclosed in Patent Literature 2 shown in FIG. 10, it is possible to reduce the number of measurements. The power storage apparatus 900 has 2ⁿ power storage elements (in FIG. 10, a case in which n=3 is shown), and impedance of each of the power storage elements can be measured through turning ON/OFF each switch, and conducting charging and discharging with another power storage element. However, the numbers of switches of the power storage apparatus 900 and a power storage apparatus 300B are, respectively, 11 and 6 when n=2, 22 and 14 when n=3, 47 and 30 when n=4, and 95 and 62 when n=5. Furthermore, the numbers of measurements are, respectively, 2 and 2 when n=2, 4 and 3 when n=3, 8 and 4 when n=4, and 16 and 5 when n=5. Therefore, the power storage apparatuses according to each mode of the technology disclosed herein can further reduce the number of switches and cost, increase efficiency by further reducing the number of measurements, and obtain a further advantageous effect. For example, if it requires 10 minutes to measure impedance of a single power storage element (power storage unit) while changing frequency (from 10 kHz to 10 mHz at 10 step/decade) of current and voltage during the measurement, when n=5, the measuring time can be shortened from 160 minutes to 50 minutes.

Since impedance of a power storage element (power storage unit) is a function of frequency of current and voltage during a measurement, it is possible to appropriately select, calculate, or make corrections depending on the configuration of a power storage element and steps that are taken, regarding at which frequency should the comparison is to be conducted, whether to conduct the comparison by suitably assigning weight to impedance data at each frequency in a specific frequency range, how much of the assigned weight should be changed by SOC, or how much weight should be assigned by temperature. For example, instead of measuring frequency of current and voltage during measurement while changing those at an equal interval in a logarithmic axis, the measurement frequency can be selected to further shorten the measuring time.

In each Example, although a power storage apparatus having 2ⁿ power storage elements connected in series has been used as a representative example, even with other number of power storage elements, there are cases where impedances of each of the power storage elements can be specified by combining comparison circuits and making additions and subtractions to measurement results, and each mode of the technology disclosed herein can be incorporated in a part thereof.

Furthermore, the power storage element which is a minimum unit for measuring impedance may be an electrochemical minimum unit referred to as "cell", or may be a combination of a plurality of cells. In any of such cases, measurement and replacement can be conducted at the power storage element level.

In the power storage apparatus according to the technology disclosed herein, it is conceivable that deterioration will not generally progress when the power storage element is brand-new. Therefore, by quickly figuring out a deteriorated power storage element using a simple circuit, it is possible to minimally suppress effect of measuring time relative to usage time, and dramatically improve maintainability by quickly figuring out deterioration.

In addition, the power storage apparatus 100 according to the first embodiment is obtained when n=2 in the power storage apparatus 300B, and the power storage apparatus 200 according to the second embodiment is obtained when n=3 in the power storage apparatus 300B. Thus, the present embodiment has the similar advantageous effect as that of the first and second embodiments.

Furthermore, in each of the examples shown in the first to third embodiments, since the power storage apparatus cannot be used as a power storage element while impedance is measured, the measurement is preferably conducted in an appropriately selected time slot, using one or more methods among a plurality of methods shown below.

As a first method, the control section C2ⁿ (n=1, 2, ...) may be formed so as to conduct the impedance-measurement process based on schedule information.

The schedule information is, for example, information specifying a time slot in which impedance is measured and including start time, and end time or process continuation time. The control section C2ⁿ may conduct the impedance-measurement process in the time slot specified by the schedule information.

As a second method, the control section C2ⁿ preferably repetitively measures impedance at an appropriate interval to monitor deterioration of the power storage apparatus.

As a third method, the above described schedule information may be configured as information indicating a plurality of time slots, and the control section C2ⁿ may appropriately select each of the time slots to conduct the impedance-measurement process.

For example, the control section C2ⁿ may set a priority level on the time slots indicated by the schedule information, and may select a time slot having a high priority level in accordance with a usage status of the power storage apparatus to conduct the impedance-measurement process. More specifically, the control section C2ⁿ may, for example, select a time slot having a high priority level among time slots that are not used by the power storage apparatus as a power storage element to conduct the impedance-measurement process.

Alternatively, as a fourth method, the control section C2ⁿ may predict the period of time required for the impedance-measurement process in advance, and prioritize an executable time slot for measuring impedance. More specifically, the control section C2ⁿ may, for example, predict a time slot that will not be used by the power storage apparatus as a power storage element, and conduct the impedance-measurement process when it is predicted that the impedance-measurement process will end in the time slot.

For example, the schedule information may be received by the power storage apparatus from an external server, may be accepted as an input from the user through a user interface included in the power storage apparatus, or may be kept in advance in information storage means such as a memory or the like included inside the power storage apparatus.

Furthermore, the schedule information may be generated by the user or the control section C2ⁿ etc., based on unused time slots learnt in advance as a time slot in which the power storage apparatus does not conduct charging or discharging.

It should be noted that a processing section for conducting a process for determining execution timing of such impedance-measurement process may be, for example, formed separately in the power storage apparatus as a schedule management section, or may be incorporated with any processing section such as the control section C2ⁿ or the like.

Alternatively, the processing section for conducting the process for determining execution timing of the impedance-measurement process may be formed on an external server, and the power storage apparatus may remotely accept control from the server and conduct start/end control of the impedance-measurement process.

With this, it is possible to measure impedance while reducing effect on a user of not being able to use the power storage apparatus as a power storage apparatus.

### INDUSTRIAL APPLICABILITY

The power storage apparatus disclosed here is useful in mobile devices and electric-powered vehicles as a power storage apparatus with a function of measuring impedance. In addition, it is also applicable for use application such as backup power supplies and the like. Furthermore, it is widely applicable for power storage apparatuses in electronic equipment other than mobile devices and electric-powered vehicles.

### DESCRIPTION OF THE REFERENCE CHARACTERS

- 1: power storage element
- 10A: frequency-sweep oscillator
- 10B: impedance measuring equipment
- 15: AC power supply
- 20A: amplifier
- 20B: voltage-current monitor
- 100, 200, 300A, 300B, 900: power storage apparatus
- B1, B2, ...: power storage element
- BU1, BU2, ...: power storage unit
- SW1, SW2, ...: switch
- L1, L2, ...: inductor
- C4, C8, C2ⁿ: control section

## Claims

1. A power storage apparatus (100, 200, 300A) having a plurality of power storage elements, the apparatus comprising:
2ⁿ, wherein n is an integer not less than 2, power storage elements (B1 to B(2ⁿ)) connected in series;
voltage measuring means (VB) and current measuring means (IB) for respectively measuring voltage and current of a first power storage unit (BUn1)consisting of first to 2ⁿ⁻¹-th power storage elements (B1 to B(2ⁿ⁻¹)) and a second power storage unit (BUn2) consisting of 2ⁿ⁻¹+1 -th to 2ⁿ-th power storage elements (B(2ⁿ⁻¹+1) to B(2ⁿ)) among the 2ⁿ power storage elements (B1 to B(2ⁿ));
a first switch (SWn1) and a second switch (SWn2) connected in series at both ends of the first to 2ⁿ-th power storage elements (B1 to B(2ⁿ));
a first inductor (Ln1), on which an inter-terminal voltage of either one of the first power storage unit (BUn1) or the power storage unit (BUn2) selected through ON/OFF actions of the first switch (SWn1) and the second switch (SWn2)is applied; and
a control section (C2ⁿ) configured to switch ON/OFF of the first switch (SWn1) and the second switch (SWn2) at a predetermined timing, wherein
the control section (C2ⁿ) switches the first switch (SWn1) and the second switch (SWn2) to sequentially form a closed circuit including the first inductor (Ln1) and either one of the first power storage unit (BUn1) or the second power storage unit (BUn2) and a closed circuit including the first inductor (Ln1) and the other one of the first power storage unit (BUn1)or the second power storage unit (BUn2) ,and measures and compares magnitudes of impedances of the first power storage unit (BUn1) and the second power storage unit (BUn2) using the voltage measuring means (VB) and the current measuring means (IB) to identify the power storage unit (BU) having a larger impedance.

2. The power storage apparatus (100) according to claim 1, wherein n equals 2 and the 2ⁿ power storage elements consist of first to fourth power storage elements (B1 to B4) connected in series; and the apparatus further comprises:
voltage measuring means (VB1 to VB4) and current measuring means (IB1 to IB4) for respectively measuring voltage and current of the first to fourth power storage elements (B1 to B4);
a third switch and a fourth switch connected in series at both ends of the first power storage element (B1) and the second power storage element (B2), and
a second inductor on which an inter-terminal voltage of either one of the first power storage element (B1) or the second power storage element (B2) selected through ON/OFF actions of the third switch and the fourth switch is applied;
a fifth switch and a sixth switch connected in series at both ends of the third power storage element (B3) and the fourth power storage element (B4), and
a third inductor on which an inter-terminal voltage of either one of the third power storage element (B3) or the fourth power storage element (B4) selected through ON/OFF actions of the fifth switch and the sixth switch is applied;
wherein the first switch and the second switch is connected in series at both ends of the first power storage unit (BU1) and the second power storage unit (BU2);
the first inductor on which an inter-terminal voltage of either one of the first power storage unit (BU1) or the second power storage unit (BU2) selected through ON/OFF actions of the first switch and the second switch is applied; and
the control section (C4) is configured to switch ON/OFF of the first to sixth switches at a predetermined timing, wherein
the control section (C4) switches the first switch and the second switch to sequentially form a closed circuit including the first inductor and either one of the first power storage unit (BU1) and the second power storage unit (BU2) and the closed circuit including the first inductor and the other one of the first power storage unit (BU1) or the second power storage unit (BU2), and measures and compares magnitudes of impedances (Z) of the first and second power storage units (BU1, BU2) using the voltage measuring means (VB1 to VB4) and the current measuring means (IB1 to IB4), and
when impedance (Z) of the first power storage unit (BU1) is larger, the control section (C4) switches the third switch and the fourth switch to sequentially form a closed circuit including the second inductor and either one of the first power storage element (B1) and the second power storage element (B2) included in the first power storage unit (BU1) and a closed circuit including the second inductor and the other one of the first power storage element (B1) or the second power storage element (B2), and measures and compares magnitude of impedances (Z) of the first power storage element (B1)and the second power storage element (B2) using the voltage measuring means (VB1 to VB4) and the current measuring means (IB1 to IB4) to identify the power storage element (B) having a larger impedance (Z), whereas
when impedance (Z) of the second power storage unit (BU2) is larger, the control section (C4) switches the fifth switch and the sixth switch to sequentially form a closed circuit including the third inductor and either one of the third power storage element (B3) and the fourth power storage element (B4) included in the second power storage unit (BU2) and a closed circuit including the third inductor and the other one of the third power storage element (B3) and the fourth power storage element (B4), measures and compares magnitude of impedances (Z) of the third power storage element (B3) and the fourth power storage element (B4) using the voltage measuring means (VB1 to VB4) and the current measuring means (IB1 to IB4) to identify the power storage element (B) having a larger impedance.

3. The power storage apparatus (100) according to claim 2, wherein the control section (C4) conducts ON/OFF control of the third and fourth switches, to measure impedance of the first and second power storage elements (B1,B2), wherein the ON/OFF control is conducted such that there is a period of time in which current is supplied from the first power storage element (B1) to the second inductor, a period of time in which current is supplied from the second inductor to the second power storage element (B2), a period of time in which current is supplied from the second power storage element (B2) to the second inductor, and a period of time in which current is supplied from the second inductor to the first power storage element (B1).

4. The power storage apparatus (100) according to claim 2, wherein the control section (C4) conducts ON/OFF control of the fifth and sixth switches, to measure impedance of the third and fourth power storage elements (B3, B4), wherein the ON/OFF control is conducted such that there is a period of time in which current is supplied from the third power storage element (B3) to the third inductor, a period of time in which current is supplied from the third inductor to the fourth power storage element (B4), a period of time in which current is supplied from the fourth power storage element (B4) to the third inductor, and a period of time in which current is supplied from the third inductor to the third power storage element (B3).

5. The power storage apparatus (100) according to claim 2, wherein the control section (C4) conducts ON/OFF control of the first and second switches, to measure impedance of the first and second power storage units (BU1, BU2), wherein the ON/OFF control is conducted such that there is a period of time in which current is supplied from the first power storage unit (BU1) to the first inductor, a period of time in which current is supplied from the first inductor to the second power storage unit (BU2), a period of time in which current is supplied from the second power storage unit (BU2) to the first inductor, and a period of time in which current is supplied from the first inductor to the first power storage unit (BU1).

6. The power storage apparatus (100) according to any of the claims 2to 5, wherein the control section (C4) compares impedance (Z) of the identified power storage element (B1 to B4) with a reference value (Za, Zb) stored by the control section (C4), and notifies about the power storage element (B1 to B4) when the impedance (Z) is larger than the reference value (Za, Zb).

7. The power storage apparatus (100) according to claim 2, wherein the control section (C4) receives schedule information which is information indicating at least one time slot in which impedance (Z) is measured, and measures impedance of the first to fourth power storage elements (B1 to B4) based on the schedule information.

8. The power storage apparatus (200, 300A) according to claim 1, wherein
the first power storage unit (BUn1) includes a first power storage element group (B'1) consisting of a first to 2ⁿ⁻²-th power storage elements and a second power storage element group (B'2) consisting of 2ⁿ⁻²+1 -th to 2ⁿ⁻¹-th power storage elements;
the second power storage unit (BUn2) includes a third power storage element group (B'3) consisting of 2ⁿ⁻¹+1 -th to 2ⁿ⁻¹+2ⁿ⁻²-th power storage elements, and a fourth power storage element group (B'4) consisting of 2ⁿ⁻¹+2ⁿ⁻²+1 -th to 2ⁿ-th power storage elements;
the apparatus further comprising:
voltage measuring means and current measuring means for respectively measuring voltage and current of the first power storage element group (B'1), the second power storage group (B'2), the third power storage element group (B'3), and the fourth power storage element group (B'4) ;
a third switch (SWn3) and a fourth switch (SWn4) connected in series at both ends of the first to 2ⁿ⁻¹-th power storage elements;
a fifth switch (SWn5) and a sixth switch (SWn6) connected in series at both ends of the 2ⁿ⁻¹+1 -th to 2ⁿ-th power storage elements;
a second inductor (Ln2) on which an inter-terminal voltage of either one of the first power storage element group (B'1) or the second power storage element group (B'2)selected through ON/OFF action of the third switch (SWn3) and the fourth switch (SWn4) is applied; and
a third inductor (Ln3) on which an inter-terminal voltage of either one of the third power storage element group (B'3) or the fourth power storage element group (B'4) selected through ON/OFF action of the fifth switch (SWn5) and the sixth switch (SWn6) is applied,
wherein the control section (C2ⁿ),
when impedance of the first power storage unit (BUn1) is larger, switches the third switch (SWn3) and the forth switch (SWN4) to sequentially form a closed circuit including the second inductor (Ln2) and either one of the first power storage element group (B'1) or the second power storage element group (B'2) and a closed circuit including the second inductor (Ln2) and the other one of the first power storage element group (B'1) or the second power storage element group (B'2) , and measures and compares magnitude of impedances of the first power storage element group (B'1) and the second power storage element group (B'2) using the voltage measuring means and the current measuring means to identify the storage element group (B') having a larger impedance, whereas
when impedance of the second power storage unit (BUn2) is larger, switches the fifth switch (SWn5) and the sixth switch (SW6) to sequentially form a closed circuit including the third inductor (Ln3) and either one of the third power storage element group (B'3) or the fourth power storage element group (B'4) and a closed circuit including the third inductor and the other one of third power storage element group (B'3) or the fourth power storage element group (B'4), and measures and compares magnitude of impedances of the third power storage element group (B'3) and the fourth power storage element group (B'4) using the voltage measuring means and the current measuring means to identify the power storage element group (B') having a larger impedance.

9. The power storage apparatus (300A) according to claim 1, wherein the control section (C2ⁿ) conducts ON/OFF control of the first switch (SWn1) and the second switch (SWn2) such that there is, at least, a period of time in which current is supplied from the first power storage unit (BUn1) to the first inductor (Ln1), a period of time in which current is supplied from the first inductor (Ln1) to the first power storage unit (BUn1), a period of time in which current is supplied from the second power storage unit (BUn2) to the first inductor (Ln1), and a period of time in which current is supplied from the first inductor (Ln1) to the second power storage unit (BUn2).

10. The power storage apparatus according to claim 8, wherein the control section (C2ⁿ) conducts ON/OFF control of the third switch (SWn3) and the fourth switch (SWn4) such that there is, at least, a period of time in which current is supplied from the first power storage element group (B'1) to the second inductor (Ln2), a period of time in which current is supplied from the second inductor (Ln2) to the first power storage element group (B'1), a period of time in which current is supplied from the second power storage element group (B'2) to the second inductor (Ln2), and a period of time in which current is supplied from the second inductor (Ln2) to the second power storage element group (B'2).

11. The power storage apparatus according to claim 8, wherein the control section (C2ⁿ) conducts ON/OFF control of the fifth switch (SWn5) and the sixth switch (SWn6) such that there is, at least, a period of time in which current is supplied from the third power storage element group (B'3) to the third inductor (Ln3), a period of time in which current is supplied from the third inductor (Ln3) to the third power storage element group (B'3), a period of time in which current is supplied from the fourth power storage element group (B'4) to the third inductor (Ln3), and a period of time in which current is supplied from the third inductor to the fourth power storage element group (B'4).

12. The power storage apparatus according to any of claims 1, and 8 to 11, wherein the control section (C2ⁿ) compares impedance (Z) of the identified power storage element group (B'1 to B'4) with a stored reference value (Za,b), and notifies about the power storage element group (B'1 to B'4) when the impedance is larger than the reference value (Za,b).

13. The power storage apparatus according to claim 1, wherein the control section (C2ⁿ) receives schedule information which is information indicating at least one time slot in which impedance (Z) is measured, and measures impedance (Z) of the power storage element group (B'1 to B'4) based on the schedule information.

14. A mobile device comprising the power storage apparatus according to any of the claims 1 to 13, wherein the mobile device operates when being supplied with power from the power storage apparatus.

15. An electric-powered vehicle comprising the power storage apparatus according to any of the claims 1 to 13, wherein the electric-powered vehicle is driven when being supplied with power from the power storage apparatus.

## Patentansprüche

1. Energiespeichervorrichtung (100, 200, 300A) mit mehreren Energiespeicherelementen, wobei die Vorrichtung umfasst:
2ⁿ Leistungsspeicherelemente (B1 - B(2ⁿ)), die in Reihe geschaltet sind, wobei n eine ganze Zahl ist, die nicht kleiner als 2 ist;
eine Spannungsmesseinrichtung (VB) und eine Strommesseinrichtung (IB) zum Messen von Spannung und Strom einer ersten Leistungsspeichereinheit (BUn1), die aus dem ersten bis 2ⁿ⁻¹-ten Energiespeicherelement (B1 bis B(2ⁿ⁻¹)) besteht, und einer zweiten Energiespeichereinheit (BUn2), die aus dem 2ⁿ⁻¹ + 1-ten bis 2ⁿ-ten Energiespeicherelement (B(2ⁿ⁻¹+1) bis B(2ⁿ)) jeweils aus den 2ⁿ Leistungsspeicherelementen (B1 - B(2ⁿ)) besteht;
einen ersten Schalter (SWn1) und einen zweiten Schalter (SWn2), die entsprechend an beiden Enden des ersten bis 2ⁿ-ten Energiespeicherelements (B1 bis B(2ⁿ)) in Reihe geschaltet sind;
eine erste Induktivität (Ln1), an der eine Zwischenanschlussspannung der ersten Energiespeichereinheit (BUn1) oder der zweiten Energiespeichereinheit (BUn2) durch Einschalten/Ausschalten des ersten Schalters (SWn1) und des zweiten Schalters (SWn2) anliegt; und
einen Steuerabschnitt (C2ⁿ), der ausgebildet ist, den ersten Schalter (SWn1) und den zweiten Schalter (SWn2) in einer vorbestimmten Zeitabfolge einzuschalten/auszuschalten, wobei
der Steuerabschnitt (C2ⁿ) den ersten Schalter (SWn1) und den zweiten Schalter (SWn2) so schaltet, das sequenziell ein geschlossener Kreis, der die erste Induktivität (Ln1) und die erste Energiespeichereinheit (BUn1) oder die zweite Energiespeichereinheit (BUn2) enthält, und ein zweiter geschlossener Kreis, der die erste Induktivität (Ln1) und die entsprechende andere Energiespeichereinheit aus der ersten Energiespeichereinheit (BUn1) und der zweiten Energiespeichereinheit (BUn2) enthält, bildet, und der ferner Größen von Impedanzen der ersten Energiespeichereinheit (BUn1) und der zweiten Energiespeichereinheit (BUn2) unter Verwendung der Spannungsmesseinrichtung (VB) und der Strommesseinrichtung (IB) misst und vergleicht, um die Energiespeichereinheit (BU) zu ermitteln, die eine größere Impedanz hat.

2. Energiespeichervorrichtung (100) nach Anspruch 1, wobei n gleich 2 ist und die 2ⁿ Energiespeicherelemente aus einem ersten bis vierten Energiespeicherelement (B1 bis B4) besteht, die in Reihe geschaltet sind; und wobei die Vorrichtung ferner umfasst:
eine Spannungsmesseinrichtung (VB1 bis VB4) und eine Strommesseinrichtung (IB1 bis IB4) zum jeweiligen Messen der Spannung und des Stroms des ersten bis vierten Energiespeicherelements (B1) bis (B4);
einen dritten Schalter und einen vierten Schalter, die entsprechend an beiden Enden des ersten Energiespeicherelements (B1) und des zweiten Energiespeicherelements (B2) in Reihe geschaltet sind, und
eine zweite Induktivität, an der eine Zwischenanschlussspannung des ersten Energiespeicherelements (B1) oder des zweiten Energiespeicherelements (B2), das durch Einschalten/Ausschalten des dritten Schalters und des vierten Schalters ausgewählt ist, anliegt;
einen fünften Schalter und einen sechsten Schalter, die entsprechend an beiden Enden des dritten Energiespeicherelements (B3) und des vierten Energiespeicherelements (B4) in Reihe geschaltet sind, und
eine dritte Induktivität, an der eine Zwischenanschlussspannung des dritten Energiespeicherelements (B3) oder des vierten Energiespeicherelements (B4), das durch Einschalten/Ausschalten des fünften Schalters und des sechsten Schalters ausgewählt ist, anliegt;
wobei der erste Schalter und der zweite Schalter an beiden Enden der ersten Energiespeichereinheit (BU1) und der zweiten Energiespeichereinheit (BU2) in Reihe geschaltet sind;
an der ersten Induktivität eine Zwischenanschlussspannung der ersten Energiespeichereinheit (BU1) oder der zweiten Energiespeichereinheit (BU2), die durch Einschalten/Ausschalten des ersten Schalters und des zweiten Schalters ausgewählt ist, anliegt; und
der Steuerabschnitt (C4) ausgebildet ist, den ersten bis sechsten Schalter in einer vorbestimmten Zeitabfolge einzuschalten/auszuschalten, wobei
der Steuerabschnitt (C4) den ersten Schalter und den zweiten Schalter so schaltet, dass sequenziell ein geschlossener Kreis, der die erste Induktivität und die erste Energiespeichereinheit (BU1) oder die zweite Energiespeichereinheit (BU2) enthält, und ein geschlossener Kreis gebildet werden, der die erste Induktivität und die andere Energiespeichereinheit aus der ersten Energiespeichereinheit (BU1) und der zweiten Energiespeichereinheit (BU2) enthält, und der ferner Größen von Impedanzen (Z) der ersten und der zweiten Energiespeichereinheit (BU1, BU2) unter Anwendung der Spannungsmesseinrichtung (VB1 bis VB 4) und der Strommesseinrichtung (IB1 bis IB4) misst und vergleicht, und
wenn die Impedanz (Z) der ersten Energiespeichereinheit (BU1) größer ist, dann schaltet der Steuerabschnitt (C4) den dritten Schalter und den vierten Schalter derart, dass ein geschlossener Kreis, der die zweite Induktivität und das erste Energiespeicherelement (B1) oder das zweite Energiespeicherelement (B2), die in der ersten Energiespeichereinheit (BU1) enthalten sind, enthält, und ein geschlossener Kreis gebildet werden, der die zweite Induktivität und das andere Energiespeicherelement aus dem ersten Energiespeicherelement (B1) und dem zweiten Energiespeicherelement (B2) enthält, und ferner die Größe von Impedanzen (Z) des ersten Energiespeicherelements (B1) und des zweiten Energiespeicherelements (B2) unter Anwendung der Spannungsmesseinrichtung (VB1 bis VB4) und der Strommesseinrichtung (IB1 bis IB4) misst und vergleicht, um das Energiespeicherelement (B) zu ermitteln, das eine größere Impedanz (Z) hat, wohingegen,
wenn die Impedanz (Z) der zweiten Energiespeichereinheit (BU2) größer ist, der Steuerabschnitt (C4) den fünften Schalter und den sechsten Schalter derart schaltet, dass ein geschlossener Kreis, der die dritte Induktivität und das dritte Energiespeicherelement (B3) oder das vierte Energiespeicherelement (B4), die in der zweiten Energiespeichereinheit (BU2) enthalten sind, enthält, und ein geschlossener Kreis gebildet werden, der die dritte Induktivität und das andere Energiespeicherelement aus dem dritten Energiespeicherelement (B3) und dem vierten Energiespeicherelement (B4) enthält, und ferner die Größe von Impedanzen (Z) des dritten Energiespeicherelements (B3) und des vierten Energiespeicherelements (B4) unter Anwendung der Spannungsmesseinrichtung (VB1 bis VB4) und der Strommesseinrichtung (IB1 bis IB4) misst und vergleicht, um das Energiespeicherelement (B) zu ermitteln, das eine größere Impedanz hat.

3. Energiespeichervorrichtung (100) nach Anspruch 2, wobei der Steuerabschnitt (C4) eine Steuerung des Einschaltens/Ausschaltens für den dritten und den vierten Schalter ausführt, um die Impedanz des ersten und des zweiten Energiespeicherelements (B1, B2) zu messen, wobei die Steuerung des Einschaltens/Ausschaltens so ausgeführt wird, dass es eine Zeitdauer, in der Strom von dem ersten Energiespeicherelement (B1) zu der zweiten Induktivität fließt, eine Zeitdauer, in der Strom von der zweiten Induktivität zu dem zweiten Energiespeicherelement (B2) fließt, eine Zeitdauer, in der Strom von dem zweiten Energiespeicherelement (B2) zu der zweiten Induktivität fließt, und eine Zeitdauer, in der Strom von der zweiten Induktivität zu dem ersten Energiespeicherelement (B1) fließt, gibt.

4. Energiespeichervorrichtung (100) nach Anspruch 2, wobei der Steuerabschnitt (C4) das Einschalten/Ausschalten des fünften und des sechsten Schalters steuert, um die Impedanz des dritten und des vierten Energiespeicherelements (B3, B4) zu messen, wobei die Steuerung des Einschaltens/Ausschaltens so ausgeführt wird, dass es eine Zeitdauer, in der Strom von dem dritten Energiespeicherelement (B3) zu der dritten Induktivität fließt, eine Zeitdauer, in der Strom von der dritten Induktivität zu dem vierten Energiespeicherelement (B4) fließt, eine Zeitdauer, in der Strom von dem vierten Energiespeicherelement (B4) zu der dritten Induktivität fließt, und eine Zeitdauer in der Strom von der dritten Induktivität zu dem dritten Energiespeicherelement (B3) fließt, gibt.

5. Energiespeichervorrichtung (100) nach Anspruch 2, wobei der Steuerabschnitt (C4) das Einschalten/Ausschalten des ersten und des zweiten Schalters steuert, um die Impedanz der ersten und der zweiten Energiespeichereinheit (BU1, BU2) zu messen, wobei die Steuerung des Einschaltens/Ausschaltens derart ausgeführt wird, dass es eine Zeitdauer, in der Strom von der ersten Energiespeichereinheit (BU1) zu der ersten Induktivität fließt, eine Zeitdauer, in der Strom von der ersten Induktivität zu der zweiten Energiespeichereinheit (BU2) fließt, eine Zeitdauer, in der Strom von der zweiten Energiespeichereinheit (BU2) zu der ersten Induktivität fließt, und eine Zeitdauer, in der Strom von der ersten Induktivität zu der ersten Energiespeichereinheit (BU1) fließt, gibt.

6. Energiespeichervorrichtung (100) nach einem der Ansprüche 2 bis 5, wobei der Steuerabschnitt (C4) die Impedanz (Z) des ermittelten Energiespeicherelements (B1 bisB4) mit einem Referenzwert (Za, Zb), der durch den Steuerabschnitt (C4) gespeichert ist, vergleicht und eine Benachrichtigung bezüglich des Energiespeicherelements (B1 bis B4) ausgibt, wenn die Impedanz (Z) größer ist als der Referenzwert (Za, Zb).

7. Energiespeichervorrichtung (100) nach Anspruch 2, wobei der Steuerabschnitt (C4) Planungsinformation empfängt, die eine Information ist, die mindestens einen Zeitabschnitt angibt, in welchem die Impedanz (Z) gemessen wird, und der Steuerabschnitt die Impedanz des ersten bis vierten Energiespeicherelements (B1 bis B4) auf der Grundlage der Planungsinformation misst.

8. Energiespeichervorrichtung (200, 300A) nach Anspruch 1, wobei
die erste Energiespeichereinheit (BUn1) eine erste Energiespeicherelementgruppe (B'1), die aus einem ersten bis 2ⁿ⁻²-ten Energiespeicherelement besteht, und eine zweite Energiespeicherelementgruppe (B'2) aufweist, die aus den 2ⁿ⁻²+1-ten bis 2ⁿ⁻⁻¹-ten Energiespeicherelement besteht;
die zweite Energiespeichereinheit (BUn2) eine dritte Energiespeicherelementgruppe (B'3), die aus dem 2ⁿ⁻¹+1-ten bis 2ⁿ⁻¹+2ⁿ⁻²-ten Energiespeicherelement besteht, und eine vierte Energiespeicherelementgruppe (B'4) aufweist, die aus dem 2ⁿ⁻¹+2ⁿ⁻²+1-ten bis 2ⁿ-ten Energiespeicherelement besteht;
die Vorrichtung ferner aufweist:
eine Spannungsmesseinrichtung und eine Strommesseinrichtung zum jeweiligen Messen von Spannung und Strom der ersten Energiespeicherelementgruppe (B'1), der zweiten Energiespeicherelementgruppe (B'2), der dritten Energiespeicherelementgruppe (B'3) und der vierten Energiespeicherelementgruppe (B'4);
einen dritten Schalter (SWn3) und einen vierten Schalter (SWn4), die entsprechend an beiden Enden des ersten bis 2ⁿ⁻¹-ten Energiespeicherelement in Reihe geschaltet sind;
einen fünften Schalter (SWn5) und einen sechsten Schalter (SWn6), die entsprechend an beiden Enden des 2ⁿ⁻¹+1-ten bis 2ⁿ-ten Energiespeicherelement in Reihe geschaltet sind;
eine zweite Induktivität (Ln2), an der eine Zwischenanschlussspannung der ersten Energiespeicherelementgruppe (B'1) oder der zweiten Energiespeicherelementgruppe (B'2), die durch Einschalten/Ausschalten des dritten Schalters (SWn3) und des vierten Schalters (SWn4) ausgewählt ist, anliegt; und
eine dritte Induktivität (Ln3), an der eine Zwischenanschlussspannung der dritten Energiespeicherelementgruppe (B'3) oder der vierten Energiespeicherelementgruppe (B'4), die durch Einschalten/Ausschalten des fünften Schalters (SWn5) und des sechsten Schalters (SWn6) ausgewählt ist, anliegt,
wobei der Steuerabschnitt (C2ⁿ),
wenn die Impedanz der ersten Energiespeichereinheit (BUn1) größer ist, den dritten Schalter (SWn3) und den vierten Schalter (SWn4) derart schaltet, dass ein geschlossener Kreis, der die zweite Induktivität (Ln2) und die erste Energiespeicherelementgruppe (B'1) oder die zweite Energiespeicherelementgruppe (B'2) enthält, und ein geschlossener Kreis gebildet werden, der die zweite Induktivität (Ln2) und die andere Energiespeicherelementgruppe aus der ersten Energiespeicherelementgruppe (B'1) und der zweiten Energiespeicherelementgruppe (B'2) enthält, und ferner die Größe von Impedanzen der ersten Energiespeicherelementgruppe (B'1) und der zweiten Energiespeicherelementgruppe (B'2) unter Anwendung der Spannungsmesseinrichtung und der Strommesseinrichtung misst und vergleicht, um die Energiespeicherelementgruppe (B') zu ermitteln, die eine größere Impedanz hat,
wohingegen
wenn die Impedanz der zweiten Energiespeichereinheit (BUn2) größer ist, der Steuerabschnitt den fünften Schalter (SWn5) und den sechsten Schalter (SWn6) derart schaltet, dass sequenziell ein geschlossener Kreis, der die dritte Induktivität (Ln3) und die dritte Energiespeicherelementgruppe (B'2) oder die vierte Energiespeicherelementgruppe (B'4) enthält, und ein geschlossener Kreis gebildet werden, der die dritte Induktivität und die andere Energiespeicherelementgruppe aus der dritten Energiespeicherelementgruppe (B'3) und der vierten Energiespeicherelementgruppe (B'4) enthält, und die Größe der Impedanzen der dritten Energiespeicherelementgruppe (B'3) und der vierten Energiespeicherelementgruppe (B'4) unter Anwendung der Spannungsmesseinrichtung und der Strommesseinrichtung misst und vergleicht, um die Energiespeicherelementgruppe (B') zu ermitteln, die eine größere Impedanz hat.

9. Energiespeichervorrichtung (300A) nach Anspruch 1, wobei der Steuerabschnitt (C2ⁿ) ein Steuern des Einschaltens/Ausschaltens des ersten Schalters (SWn1) und des zweiten Schalters (SWn2) derart ausführt, dass es zumindest eine Zeitdauer, in der Strom von der ersten Energiespeichereinheit (BUn1) zu der ersten Induktivität (Ln1) fließt, eine Zeitdauer, in der Strom von der ersten Induktivität (Ln1) zu der ersten Energiespeichereinheit (BUn1) fließt, eine Zeitdauer, in der Strom von der zweiten Energiespeichereinheit (BUn2) zu der ersten Induktivität (Ln1) fließt, und eine Zeitdauer, in der Strom von der ersten Induktivität (Ln1) zu der zweiten Energiespeichereinheit (BUn2) fließt, gibt.

10. Energiespeichervorrichtung nach Anspruch 8, wobei der Steuerabschnitt (C2ⁿ) eine Steuerung des Einschaltens/Ausschaltens des dritten Schalters (SWn3) und des vierten Schalters (SWn4) derart ausführt, dass es zumindest eine Zeitdauer, in der Strom von der ersten Energiespeicherelementgruppe (B'1) zu der zweiten Induktivität (Ln2) fließt, eine Zeitdauer, in der Strom von der zweiten Induktivität (Ln2) zu der ersten Energiespeicherelementgruppe (B'1) fließt, eine Zeitdauer, in der Strom von der zweiten Energiespeicherelementgruppe (B'2) zu der zweiten Induktivität (Ln2) fließt, und eine Zeitdauer, in der Strom von der zweiten Induktivität (Ln2) zu der zweiten Energiespeicherelementgruppe (B'2) fließt, gibt.

11. Energiespeichervorrichtung nach Anspruch 8, wobei der Steuerabschnitt (C2ⁿ) eine Steuerung des Einschaltens/Ausschaltens des fünften Schalters (SWn5) und des sechsten Schalters (SWn6) derart ausführt, dass es mindestens eine Zeitdauer, in der Strom von der dritten Energiespeicherelementgruppe (B'3) zu der dritten Induktivität (Ln3) fließt, eine Zeitdauer in der Strom von der dritten Induktivität (Ln3) zu der dritten Energiespeicherelementgruppe (B'3) fließt, eine Zeitdauer, in der Strom von der vierten Energiespeicherelementgruppe (B'4) zu der dritten Induktivität (Ln3) und eine Zeitdauer, in der Strom von der dritten Induktivität zu der vierten Energiespeicherelementgruppe (B'4) fließt, gibt.

12. Energiespeichervorrichtung nach einem der Ansprüche 1 oder 8 bis 11, wobei der Steuerabschnitt (C2ⁿ) die Impedanz (Z) der ermittelten Energiespeicherelementgruppe (B'1 bis B'4) mit einem gesteigerten Referenzwert (Za, b), vergleicht, und eine Benachrichtigung bezüglich der Energiespeicherelementgruppe (B'1 bis B'4) ausgibt, wenn die Impedanz größer ist als der Referenzwert (Za, b).

13. Energiespeichervorrichtung nach Anspruch 1, wobei der Steuerabschnitt (C2ⁿ) Planungsinformation empfängt, die eine Information gibt, die mindestens einen Zeitabschnitt angibt, in welchem die Impedanz (Z) gemessen wird, und der Steuerabschnitt die Impedanz (Z) der Energiespeicherelementgruppe (B'1 bis B'4) auf der Grundlage der Planungsinformation misst.

14. Mobile Einrichtung mit der Energiespeichervorrichtung nach einem der Ansprüche 1 bis 13, wobei die mobile Einrichtung in Betrieb geht, wenn Leistung aus der Energiespeichervorrichtung zugeführt wird.

15. Elektrisch angetriebenes Fahrzeug mit der Energiespeichervorrichtung nach einem der Ansprüche 1 bis 13, wobei das elektrisch angetriebene Fahrzeug angetrieben wird, wenn es mit Leistung aus der Energiespeichervorrichtung versorgt wird.

## Revendications

1. Appareil de stockage d'énergie (100, 200, 300A) comportant une pluralité d'éléments de stockage d'énergie, l'appareil comprenant :
2ⁿ éléments de stockage d'énergie (B1 à B(2ⁿ)) connectés en série, dans lequel n est un entier supérieur ou égal à 2 ;
un moyen de mesure de tension (VB) et un moyen de mesure de courant (IB) pour mesurer respectivement une tension et un courant d'une première unité de stockage d'énergie (BUn1) constituée de premier à 2ⁿ⁻¹-ième éléments de stockage d'énergie (B1 à B(2ⁿ⁻¹)) et d'une deuxième unité de stockage d'énergie (BUn2) constituée de 2ⁿ⁻¹+1-ième à 2ⁿ⁻ ième éléments de stockage d'énergie (B(2ⁿ⁻¹+1) à B(2ⁿ)) parmi les 2ⁿ éléments de stockage d'énergie (B1 à B(2ⁿ)) ;
un premier commutateur (SWn1) et un deuxième commutateur (SWn2) connectés en série aux deux extrémités des premier à 2ⁿ-ième éléments de stockage d'énergie (B1 à B(2ⁿ)) ;
une première bobine d'induction (Ln1), à laquelle est appliquée une tension entre bornes soit de la première unité de stockage d'énergie (BUn1), soit de l'unité de stockage d'énergie (BUn2), sélectionnée via des actions ALLUMER/ÉTEINDRE du premier commutateur (SWn1) et du deuxième commutateur (SWn2) ; et
une section de contrôle (C2ⁿ) configurée pour ALLUMER/ÉTEINDRE le premier commutateur (SWn1) et le deuxième commutateur (SWn2) selon une synchronisation prédéterminée, dans lequel
la section de contrôle (C2ⁿ) commute le premier commutateur (SWn1) et le deuxième commutateur (SWn2) pour former séquentiellement un circuit fermé incluant la première bobine d'induction (Ln1) et soit la première unité de stockage d'énergie (BUn1), soit la deuxième unité de stockage d'énergie (BUn2), et un circuit fermé incluant la première bobine d'induction (Ln1) et l'autre unité parmi soit la première unité de stockage d'énergie (BUn1), soit la deuxième unité de stockage d'énergie (BUn2), et mesure et compare les grandeurs d'impédance de la première unité de stockage d'énergie (BUn1) et de la deuxième unité de stockage d'énergie (BUn2) en utilisant le moyen de mesure de tension (VB) et le moyen de mesure de courant (IB) pour identifier l'unité de stockage d'énergie (BU) ayant la plus grande impédance.

2. Appareil de stockage d'énergie (100) selon la revendication 1, dans lequel n est égal à 2 et les 2ⁿ éléments de stockage d'énergie consistent en des premier à quatrième éléments de stockage d'énergie (B1 à B4) connectés en série ; et l'appareil comprend en outre :
des moyens de mesure de tension (VB1 à VB4) et des moyens de mesure de courant (IB1 à IB4) pour mesurer respectivement la tension et le courant des premier à quatrième éléments de stockage d'énergie (B1 à B4) ;
un troisième commutateur et un quatrième commutateur connectés en série aux deux extrémités du premier élément de stockage d'énergie (B1) et du deuxième élément de stockage d'énergie (B2), et
une deuxième bobine d'induction à laquelle est appliquée une tension entre bornes soit du premier élément de stockage d'énergie (B1), soit du deuxième élément de stockage d'énergie (B2), sélectionné via des actions ALLUMER/ÉTEINDRE du troisième commutateur et du quatrième commutateur ;
un cinquième commutateur et un sixième commutateur connectés en série aux deux extrémités du troisième élément de stockage d'énergie (B3) et du quatrième élément de stockage d'énergie (B4), et
une troisième bobine d'induction à laquelle est appliquée une tension entre bornes soit du troisième élément de stockage d'énergie (B3), soit du quatrième élément de stockage d'énergie (B4), sélectionné via des actions ALLUMER/ÉTEINDRE du cinquième commutateur et du sixième commutateur ;
dans lequel le premier commutateur et le deuxième commutateur sont connectés en série aux deux extrémités de la première unité de stockage d'énergie (BU1) et de la deuxième unité de stockage d'énergie (BU2) ;
la première bobine d'induction à laquelle est appliquée une tension entre bornes soit de la première unité de stockage d'énergie (BU1), soit de la deuxième unité de stockage d'énergie (BU2), sélectionnée via des actions ALLUMER/ÉTEINDRE du premier commutateur et du deuxième commutateur ; et
la section de contrôle (C4) est configurée pour ALLUMER/ÉTEINDRE les premier à sixième commutateurs selon une synchronisation prédéterminée, dans lequel
la section de contrôle (C4) commute le premier commutateur et le deuxième commutateur pour former séquentiellement un circuit fermé incluant la première bobine d'induction et soit la première unité de stockage d'énergie (BU1), soit la deuxième unité de stockage d'énergie (BU2), et le circuit fermé incluant la première bobine d'induction et l'autre unité parmi soit la première unité de stockage d'énergie (BU1), soit la deuxième unité de stockage d'énergie (BU2), et mesure et compare les grandeurs d'impédance (Z) des première et deuxième unités de stockage d'énergie (BU1, BU2) en utilisant les moyens de mesure de tension (VB1 à VB4) et les moyens de mesure de courant (IB1 à IB4), et
quand l'impédance (Z) de la première unité de stockage d'énergie (BU1) est plus grande, la section de contrôle (C4) commute le troisième commutateur et le quatrième commutateur pour former séquentiellement un circuit fermé incluant la deuxième bobine d'induction et soit le premier élément de stockage d'énergie (B1), soit le deuxième élément de stockage d'énergie (B2) inclus dans la première unité de stockage d'énergie (BU1), et un circuit fermé incluant la deuxième bobine d'induction et l'autre élément parmi soit le premier élément de stockage d'énergie (B1), soit le deuxième élément de stockage d'énergie (B2), et mesure et compare les grandeurs d'impédance (Z) du premier élément de stockage d'énergie (B1) et du deuxième élément de stockage d'énergie (B2) en utilisant les moyens de mesure de tension (VB1 à VB4) et les moyens de mesure de courant (IB1 à IB4) pour identifier l'élément de stockage d'énergie (B) ayant la plus grande impédance (Z), alors que
quand l'impédance (Z) de la deuxième unité de stockage d'énergie (BU2) est plus grande, la section de contrôle (C4) commute le cinquième commutateur et le sixième commutateur pour former séquentiellement un circuit fermé incluant la troisième bobine d'induction et soit le troisième élément de stockage d'énergie (B3), soit le quatrième élément de stockage d'énergie (B4) inclus dans la deuxième unité de stockage d'énergie (BU2), et un circuit fermé incluant la troisième bobine d'induction et l'autre élément parmi soit le troisième élément de stockage d'énergie (B3), soit le quatrième élément de stockage d'énergie (B4), et mesure et compare les grandeurs d'impédance (Z) du troisième élément de stockage d'énergie (B3) et du quatrième élément de stockage d'énergie (B4) en utilisant les moyens de mesure de tension (VB1 à VB4) et les moyens de mesure de courant (IB1 à IB4) pour identifier l'élément de stockage d'énergie (B) ayant la plus grande impédance.

3. Appareil de stockage d'énergie (100) selon la revendication 2, dans lequel la section de contrôle (C4) met en œuvre un contrôle ALLUMAGE/EXTINCTION des troisième et quatrième commutateurs, pour mesurer l'impédance des premier et deuxième éléments de stockage d'énergie (B1, B2), dans lequel le contrôle ALLUMAGE/EXTINCTION est mis en œuvre de telle sorte qu'il y ait une période durant laquelle un courant est fourni par le premier élément de stockage d'énergie (B1) à la deuxième bobine d'induction, une période durant laquelle un courant est fourni par la deuxième bobine d'induction au deuxième élément de stockage d'énergie (B2), une période durant laquelle un courant est fourni par le deuxième élément de stockage d'énergie (B2) à la deuxième bobine d'induction, et une période durant laquelle un courant est fourni par la deuxième bobine d'induction au premier élément de stockage d'énergie (B1).

4. Appareil de stockage d'énergie (100) selon la revendication 2, dans lequel la section de contrôle (C4) met en œuvre un contrôle ALLUMAGE/EXTINCTION des cinquième et sixième commutateurs pour mesurer l'impédance des troisième et quatrième éléments de stockage d'énergie (B3, B4), dans lequel le contrôle ALLUMAGE/EXTINCTION est mis en œuvre de telle sorte qu'il y ait une période durant laquelle un courant est fourni par le troisième élément de stockage d'énergie (B3) à la troisième bobine d'induction, une période durant laquelle un courant est fourni par la troisième bobine d'induction au quatrième élément de stockage d'énergie (B4), une période durant laquelle un courant est fourni par le quatrième élément de stockage d'énergie (B4) à la troisième bobine d'induction, et une période durant laquelle un courant est fourni par la troisième bobine d'induction au troisième élément de stockage d'énergie (B3).

5. Appareil de stockage d'énergie (100) selon la revendication 2, dans lequel la section de contrôle (C4) met en œuvre un contrôle ALLUMAGE/EXTINCTION des premier et deuxième commutateurs pour mesurer l'impédance des première et deuxième unités de stockage d'énergie (BU1, BU2), dans lequel le contrôle ALLUMAGE/EXTINCTION est mis en œuvre de telle sorte qu'il y ait une période durant laquelle un courant est fourni par la première unité de stockage d'énergie (BU1) à la première bobine d'induction, une période durant laquelle un courant est fourni par la première bobine d'induction à la deuxième unité de stockage d'énergie (BU2), une période durant laquelle un courant est fourni par la deuxième unité de stockage d'énergie (BU2) à la première bobine d'induction, et une période durant laquelle un courant est fourni par la première bobine d'induction à la première unité de stockage d'énergie (BU1).

6. Appareil de stockage d'énergie (100) selon l'une quelconque des revendications 2 à 5, dans lequel la section de contrôle (C4) compare l'impédance (Z) de l'élément de stockage d'énergie identifié (B1 à B4) à une valeur de référence (Za, Zb) stockée par la section de contrôle (C4), et notifie concernant l'élément de stockage d'énergie (B1 à B4) quand l'impédance (Z) est supérieure à la valeur de référence (Za, Zb).

7. Appareil de stockage d'énergie (100) selon la revendication 2, dans lequel la section de contrôle (C4) reçoit de l'information de programmation temporelle qui indique au moins un créneau temporel durant lequel l'impédance (Z) est mesurée, et mesure l'impédance des premier à quatrième éléments de stockage d'énergie (B1 à B4) sur base de l'information de programmation temporelle.

8. Appareil de stockage d'énergie (200, 300A) selon la revendication 1, dans lequel
la première unité de stockage d'énergie (BUn1) comprend un premier groupe d'éléments de stockage d'énergie (B'1) constitué de premier à 2ⁿ⁻²-ième éléments de stockage d'énergie et un deuxième groupe d'éléments de stockage d'énergie (B'2) constitué de 2ⁿ⁻²+1-ième à 2ⁿ⁻¹-ième éléments de stockage d'énergie ;
la deuxième unité de stockage d'énergie (BUn2) comprend un troisième groupe d'éléments de stockage d'énergie (B'3) constitué de 2ⁿ⁻¹+1-ième à 2ⁿ⁻¹+2ⁿ⁻²-ième éléments de stockage d'énergie, et un quatrième groupe d'éléments de stockage d'énergie (B'4) constitué de 2ⁿ⁻¹+2ⁿ⁻²+1-ième à 2ⁿ-ième éléments de stockage d'énergie ;
l'appareil comprenant en outre :
un moyen de mesure de tension et un moyen de mesure de courant pour mesurer respectivement la tension et le courant du premier groupe d'éléments de stockage d'énergie (B'1), du deuxième groupe d'éléments de stockage d'énergie (B'2), du troisième groupe d'éléments de stockage d'énergie (B'3) et du quatrième groupe d'éléments de stockage d'énergie (B'4) ;
un troisième commutateur (SWn3) et un quatrième commutateur (SWn4) connectés en série aux deux extrémités desdits premier à 2ⁿ⁻¹-ième éléments de stockage d'énergie ;
un cinquième commutateur (SWn5) et un sixième commutateur (SWn6) connectés en série aux deux extrémités desdits 2ⁿ⁻¹+1-ième à 2ⁿ-ième éléments de stockage d'énergie ;
une première bobine d'induction (Ln2) à laquelle est appliquée une tension entre bornes soit du premier groupe d'éléments de stockage d'énergie (B'1), soit du deuxième groupe d'éléments de stockage d'énergie (B'2), sélectionné via des actions ALLUMER/ÉTEINDRE du troisième commutateur (SWn3) et du quatrième commutateur (SWn4) ; et
une troisième bobine d'induction (Ln3) à laquelle est appliquée une tension entre bornes soit du troisième groupe d'éléments de stockage d'énergie (B'3), soit du quatrième groupe d'éléments de stockage d'énergie (B'4), sélectionné via des actions ALLUMER/ÉTEINDRE du cinquième commutateur (SWn5) et du sixième commutateur (SWn6),
dans lequel la section de contrôle (C2ⁿ),
quand l'impédance de la première unité de stockage d'énergie (BUn1) est plus grande, commute le troisième commutateur (SWn3) et le quatrième commutateur (SWN4) pour former séquentiellement un circuit fermé incluant la deuxième bobine d'induction (Ln2) et soit le premier groupe d'éléments de stockage d'énergie (B'1), soit le deuxième groupe d'éléments de stockage d'énergie (B'2), et un circuit fermé incluant la deuxième bobine d'induction (Ln2) et l'autre groupe parmi soit le premier groupe d'éléments de stockage d'énergie (B'1), soit le deuxième groupe d'éléments de stockage d'énergie (B'2), et mesure et compare les grandeurs d'impédance du premier groupe d'éléments de stockage d'énergie (B'1) et du deuxième groupe d'éléments de stockage d'énergie (B'2) en utilisant les moyens de mesure de tension et les moyens de mesure de courant pour identifier le groupe d'éléments de stockage (BU) ayant la plus grande impédance, mais
quand l'impédance de la deuxième unité de stockage d'énergie (BUn2) est plus grande, commute le cinquième commutateur (SWn5) et le sixième commutateur (SWN6) pour former séquentiellement un circuit fermé incluant la troisième bobine d'induction (Ln3) et soit le troisième groupe d'éléments de stockage d'énergie (B'3), soit le quatrième groupe d'éléments de stockage d'énergie (B'4), et un circuit fermé incluant la troisième bobine d'induction et l'autre groupe parmi soit le troisième groupe d'éléments de stockage d'énergie (B'3), soit le quatrième groupe d'éléments de stockage d'énergie (B'4), et mesure et compare les grandeurs d'impédance du troisième groupe d'éléments de stockage d'énergie (B'3) et du quatrième groupe d'éléments de stockage d'énergie (B'4) en utilisant les moyens de mesure de tension et les moyens de mesure de courant pour identifier le groupe d'éléments de stockage d'énergie (B') ayant la plus grande impédance.

9. Appareil de stockage d'énergie (300A) selon la revendication 1, dans lequel la section de contrôle (C2ⁿ) met en œuvre un contrôle ALLUMAGE/EXTINCTION du premier commutateur (SWn1) et du deuxième commutateur (SWn2) de telle sorte qu'il y ait au moins une période durant laquelle un courant est fourni par la première unité de stockage d'énergie (BUn1) à la première bobine d'induction (Ln1), une période durant laquelle un courant est fourni par la première bobine d'induction (Ln1) à la première unité de stockage d'énergie (BUn1), une période durant laquelle un courant est fourni par la deuxième unité de stockage d'énergie (BUn2) à la première bobine d'induction (Ln1), et une période durant laquelle un courant est fourni par la première bobine d'induction (Ln1) à la deuxième unité de stockage d'énergie (BUn2).

10. Appareil de stockage d'énergie selon la revendication 8, dans lequel la section de contrôle (C2ⁿ) met en œuvre un contrôle ALLUMAGE/EXTINCTION du troisième commutateur (SWn3) et du quatrième commutateur (SWn4) de telle sorte qu'il y ait au moins une période durant laquelle un courant est fourni par le premier groupe d'éléments de stockage d'énergie (B'1) à la deuxième bobine d'induction (Ln2), une période durant laquelle un courant est fourni par la deuxième bobine d'induction (Ln2) au premier groupe d'éléments de stockage d'énergie (B'1), une période durant laquelle un courant est fourni par le deuxième groupe d'éléments de stockage d'énergie (B'2) à la deuxième bobine d'induction (Ln2), et une période durant laquelle un courant est fourni par la deuxième bobine d'induction (Ln2) au deuxième groupe d'éléments de stockage d'énergie (B'2).

11. Appareil de stockage d'énergie selon la revendication 8, dans lequel la section de contrôle (C2ⁿ) met en œuvre un contrôle ALLUMAGE/EXTINCTION du cinquième commutateur (SWn5) et du sixième commutateur (SWn6) de telle sorte qu'il y ait au moins une période durant laquelle un courant est fourni par le troisième groupe d'éléments de stockage d'énergie (B'3) à la troisième bobine d'induction (Ln3), une période durant laquelle un courant est fourni par la troisième bobine d'induction (Ln3) au troisième groupe d'éléments de stockage d'énergie (B'3), une période durant laquelle un courant est fourni par le quatrième groupe d'éléments de stockage d'énergie (B'4) à la troisième bobine d'induction (Ln3), et une période durant laquelle un courant est fourni par la troisième bobine d'induction au quatrième groupe d'éléments de stockage d'énergie (B'4).

12. Appareil de stockage d'énergie selon l'une quelconque des revendications 1 et 8 à 11, dans lequel la section de contrôle (C2ⁿ) compare l'impédance (Z) du groupe d'éléments de stockage d'énergie identifié (B'1 à B'4) à une valeur de référence stockée (Za,b), et notifie concernant le groupe d'éléments de stockage d'énergie (B'1 à B'4) quand l'impédance est supérieure à la valeur de référence (Za,b).

13. Appareil de stockage d'énergie selon la revendication 1, dans lequel la section de contrôle (C2ⁿ) reçoit de l'information de programmation temporelle qui indique au moins un créneau temporel durant lequel l'impédance (Z) est mesurée, et mesure l'impédance (Z) du groupe d'éléments de stockage d'énergie (B'1 à B'4) sur base de l'information de programmation temporelle.

14. Dispositif mobile comprenant l'appareil de stockage d'énergie selon l'une quelconque des revendications 1 à 13, dans lequel le dispositif mobile fonctionne quand il est alimenté en énergie par l'appareil de stockage d'énergie.

15. Véhicule à propulsion électrique comprenant l'appareil de stockage d'énergie selon l'une quelconque des revendications 1 à 13, dans lequel le véhicule à propulsion électrique est propulsé quand il est alimenté en énergie par l'appareil de stockage d'énergie.
